(19) Europäisches Patentamt
European Patent Office
Office européen des brevets

(11) **EP 3 232 207 B1**

(12) **EUROPEAN PATENT SPECIFICATION**

(45) Date of publication and mention of the grant of the patent:
**02.10.2019 Bulletin 2019/40**

(21) Application number: **15867012.5**

(22) Date of filing: **04.12.2015**

(51) Int Cl.:
*G01R 21/06* (2006.01)    *G01R 21/00* (2006.01)

(86) International application number:
**PCT/ES2015/070879**

(87) International publication number:
**WO 2016/092133 (16.06.2016 Gazette 2016/24)**

(54) **METHOD AND SYSTEM FOR MEASURING IMBALANCES IN AN ELECTRICAL GRID**

VERFAHREN UND SYSTEM ZUM MESSEN VON UNSYMMETRIEN IN EINEM STROMNETZ

MÉTHODE ET SYSTÈME DE MESURE DE DÉSÉQUILIBRES SUR UN RÉSEAU ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.12.2014 ES 201431822**

(43) Date of publication of application:
**18.10.2017 Bulletin 2017/42**

(73) Proprietor: **Universitat Politècnica de València 46022 València (ES)**

(72) Inventors:
• **LEON MARTINEZ, Vicente**
46022 Valencia (ES)
• **MONTAÑANA ROMEU, Joaquin**
46022 Valencia (ES)

(74) Representative: **Maslanka Kubik, Dorota Irena C/Vara de Rey 5 TER, 3, Oficina 5 26003 Logroño (La Rioja) (ES)**

(56) References cited:
EP-A1- 2 149 795    WO-A1-2010/007186
WO-A1-2011/004050    WO-A1-2012/164120
ES-A1- 2 215 467    ES-A1- 2 316 280
ES-A1- 2 342 528    US-A1- 2013 054 204
US-A1- 2014 125 314    US-A1- 2014 239 939
US-B1- 6 246 332

• FERREIRA S C ET AL: "Adaptive algorithm for real-time power quality measurement according to IEEE Std. 1459 2000", POWER ELECTRONICS CONFERENCE (COBEP), 2011 BRAZILIAN, IEEE, 11 September 2011 (2011-09-11), pages 249-255, XP031999363, DOI: 10.1109/COBEP.2011.6085257 ISBN: 978-1-4577-1644-7
• FERRERO ET AL: "Measuring electric power quality: Problems and perspectives", MEASUREMENT, INSTITUTE OF MEASUREMENT AND CONTROL. LONDON, GB, vol. 41, no. 2, 8 January 2008 (2008-01-08), pages 121-129, XP022413233, ISSN: 0263-2241, DOI: 10.1016/J.MEASUREMENT.2006.03.004
• LEON-MARTINEZ V ET AL: "Phasor Total Unbalance Power: Formulation and some properties", INSTRUMENTATION AND MEASUREMENT TECHNOLOGY CONFERENCE PROCEEDINGS, 2007 IEEE, IEEE, PI, 1 May 2007 (2007-05-01), pages 1-6, XP031182551, ISBN: 978-1-4244-0588-6
• EMANUEL A E: "THE BUCHHOLZ-GOODHUE APPARENT POWER DEFINITION: THE PRACTICAL APPROACH FOR NONSINUSOIDAL AND UNBALANCED SYSTEMS", IEEE TRANSACTIONS ON POWER DELIVERY, IEEE SERVICE CENTER, NEW YORK, NY, US, vol. 13, no. 2, 1 April 1998 (1998-04-01), pages 344-350, XP011049481, ISSN: 0885-8977, DOI: 10.1109/61.660900

EP 3 232 207 B1

- CZARNECKI L S: "POWER RELATED PHENOMENA IN THREE-PHASE UNBALANCED SYSTEMS", IEEE TRANSACTIONS ON POWER DELIVERY, IEEE SERVICE CENTER, NEW YORK, NY, US, vol. 10, no. 3, 1 July 1995 (1995-07-01), pages 1168-1176, XP000557303, ISSN: 0885-8977, DOI: 10.1109/61.400893
- ARSENEAU R ET AL: "IEEE WORKING GROUP ON NONSINUSOIDAL SITUATIONS: EFFECTS ON METER PERFORMANCE AND DEFINITIONS OF POWER", IEEE TRANSACTIONS ON POWER DELIVERY, IEEE SERVICE CENTER, NEW YORK, NY, US, vol. 11, no. 1, 1 January 1996 (1996-01-01), pages 79-101, XP011049029, ISSN: 0885-8977
- MOREIRA ET AL: "Virtual Instrumentation Applied to the Implementation of IEEE-STD 1459-2000 Power Definitions", POWER ELECTRONICS SPECIALISTS CONFERENCE, 2005. PESC '05. IEEE 36TH, IEEE, PISCATAWAY, NJ, USA, 1 January 2005 (2005-01-01), pages 1712-1718, XP031000376, DOI: 10.1109/PESC.2005.1581861 ISBN: 978-0-7803-9033-1
- MORSI W G ET AL: "Defining Power Components in Nonsinusoidal Unbalanced Polyphase Systems: The Issues", IEEE TRANSACTIONS ON POWER DELIVERY, IEEE SERVICE CENTER, NEW YORK, NY, US, vol. 22, no. 4, 1 October 2007 (2007-10-01), pages 2428-2438, XP011191865, ISSN: 0885-8977, DOI: 10.1109/TPWRD.2007.905344
- SALVADOR ORTS-GRAU ET AL: "Discussion on Useless Active and Reactive Powers Contained in the IEEE Standard 1459", IEEE TRANSACTIONS ON POWER DELIVERY, IEEE SERVICE CENTER, NEW YORK, NY, US, vol. 26, no. 2, 1 April 2011 (2011-04-01), pages 640-649, XP011351251, ISSN: 0885-8977, DOI: 10.1109/TPWRD.2010.2096519
- SEGUI-CHILET ET AL: "Approach to unbalance power active compensation under linear load unbalances and fundamental voltage asymmetries", INTERNATIONAL JOURNAL OF ELECTRICAL POWER & ENERGY SYSTEMS, JORDAN HILL, OXFORD, GB, vol. 29, no. 7, 21 June 2007 (2007-06-21), pages 526-539, XP022126091, ISSN: 0142-0615

**Description**

TECHNICAL FIELD OF THE INVENTION

The present invention generally relates to the field of the control and maintenance of electrical grids and systems, and more specifically to measuring the energetic effects of voltage imbalances on the operation of three- and four-wire three-phase electrical systems, with balanced and unbalanced receivers.

PRIOR ART

Different formulations are known in the prior art for imbalance power, which is the magnitude in charge of measuring the effects of imbalances on electrical systems (see, for example, L.S. Czarnecki, "Power related phenomena in three-phase unbalanced systems", IEEE Trans on Power Delivery, vol. 10, no. 3, July 1995; A. E. Emanuel, "The Buchholz-Goodhue Apparent Power definition: The practical approach for non-sinusoidal and unbalanced systems", IEEE Trans on Power Delivery, vol. 13, no. 2, April 1998). A much-used expression of the imbalance power ($S_u$) is the following, included in the draft for IEEE standard 1459-2010, of the Institute of Electrical and Electronic Engineers of the United States of America, depending on the apparent power at the fundamental frequency ($S_1$) and the positive-sequence apparent power ($S_+$):

$$S_{u=} \sqrt{S_1^2 - S_+^2}$$

wherein the expressions of these apparent powers are:

$$S_1 = 3\sqrt{(V_+^2 + V_-^2 + V_o^2)\cdot(I_+^2 + I_-^2 + I_o^2)}$$

$$S_+ = 3V_+ I_+$$

wherein the subscripts +, - and 0 respectively refer to positive (direct), negative (inverse) and zero (homopolar) sequence components of the phase voltages and currents of the system.

The preceding expressions of apparent powers are preferred in that they are more closely related to the physical phenomena present in electrical systems, in that the voltages and currents therein verify the Kirchhoff's laws, and in that the first of the apparent powers provides the same results as Buchholz's apparent power (1922). Therefore, the effects of imbalances, measured by power $S_u$, thereby obtained, are understood to be closer to what the phenomenon is actually like than those effects that are deduced from the use of other expressions of apparent power with more mathematical significance are.

However, the use of power $S_u$ to measure the effects of imbalances on electrical systems is very limited, since this magnitude is not conservative, and therefore, the total imbalance power of an electrical installation or grid is not obtained as the sum of the imbalance powers of each of its receivers. Likewise, $S_u$ does not provide information about whether the imbalance is due to resistive or reactive loads, or in which phase or phases the imbalances are more significant.

To avoid this drawback of $S_u$, Spanish patent ES 2 316 280 B1 (see also EP2149795A1), belonging to the same inventors as the present document, discloses a method and system for measuring the so-called "imbalance power phasor" ($\overline{A}_u$), a term that was used for the first time in said patent. The modulus of the imbalance power phasor coincides with the value of $S_u$ when system voltages are balanced. The imbalance power phasor is useful for measuring the effects of load imbalances and prevents some of the problems with imbalance power $S_u$. Depending on the active and reactive powers ($P_z$, $\overline{Q}_z$) of each phase of the system (z = 1, 2, 3), the imbalance power phasor is expressed as follows:

$$\overline{A}_u = \sqrt{2}\cdot\left(\left|P_1^b + a^2 P_2^b + a\,P_3^b\right|\cdot\overline{p} + \left|\overline{Q}_1^b + a^2\overline{Q}_2^b + a\,\overline{Q}_3^b\right|\cdot\overline{q}\right)$$

wherein $a = 1\angle120°$; $\overline{p},\overline{q}$ are the orthogonal coordinate axes defining the plane where the imbalance power phasor is represented and superscript b denotes that said powers correspond to balanced voltages.

Therefore, the imbalance power phasor presents certain advantages with respect to $S_u$. However, it does not measure the effects caused by voltage imbalances; therefore, use thereof is limited to the analysis of imbalances produced by electrical loads when supply voltages are perfectly balanced or have very minor imbalances.

From the energy viewpoint, voltage imbalances in electrical systems intervene in two ways: on one hand, they disturb the power flows brought about by load imbalances; and on the other hand, give rise to a power flow characteristic of the voltage imbalance, which is defined in a dimension other than the plane of the load imbalance. In other words, the complete measurement of the energetic effects of imbalances on electrical systems requires a vector magnitude, represented in a three-dimensional space $(\overline{p}, \overline{q}, \overline{z})$.

Therefore, there continues to be a need in the art for a method and system that allow measuring imbalances in an electrical grid due to both effects of load imbalances and effects of voltage imbalances.

BRIEF DISCLOSURE OF THE INVENTION

According to a first aspect, the present invention discloses a method for measuring imbalances in an electrical grid comprising the steps of:

i) obtaining effective values ($V_{A1}$, $V_{B1}$, $V_{C1}$) and arguments ($\alpha_{A1}$, $\alpha_{B1}$, $\alpha_{C1}$) of the phase voltages at the fundamental frequency, as well as effective values ($I_{A1}$, $I_{B1}$, $I_{C1}$) and arguments ($\beta_{A1}$, $\beta_{B1}$, $\beta_{C1}$) of the phase currents at the fundamental frequency of the electrical grid;

ii) calculating the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_o = V_{A1o}$);

iii) determining the active power ($P_{A1}$, $P_{B1}$, $P_{C1}$) and reactive power ($\overline{Q}_{A1}$, $\overline{Q}_{B1}$, $\overline{Q}_{C1}$) of each of the phases at the fundamental frequency from the values of the voltages and currents at the fundamental frequency; and

iv) calculating the value of the imbalance power vector ($\overline{S}_u$) according to the following equation:

$$\overline{S}_u = V_+ \sqrt{2 + 2\delta_u^2 + 2\delta_A^2} \cdot \left( \left| \begin{array}{l} \frac{P_{A1}}{V_{A1}} \cos(\alpha_+ - \alpha_{A1}) + j\frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \\ + j a^2 \frac{\overline{Q}_{B1}}{V_{B1}} \sin(\alpha_+ - \alpha_{B1}) + a\frac{P_{C1}}{V_{C1}} \cos(\alpha_+ - \alpha_{C1}) + j a\frac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\frac{P_{A1}}{V_{A1}} \sin(\alpha_+ - \alpha_{A1}) + \frac{\overline{Q}_{A1}}{V_{A1}} \cos(\alpha_+ - \alpha_{A1}) + j a^2 \frac{P_{B1}}{V_{B1}} \sin(\alpha_+ - \alpha_{B1}) + \\ + a^2 \frac{\overline{Q}_{B1}}{V_{B1}} \cos(\alpha_+ - \alpha_{B1}) + j a\frac{P_{C1}}{V_{C1}} \sin(\alpha_+ - \alpha_{C1}) + a\frac{\overline{Q}_{C1}}{V_{C1}} \cos(\alpha_+ - \alpha_{C1}) \end{array} \right| \cdot \overline{q} \right) +$$

$$+ V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

wherein

$$a = 1 \angle 120^o ;$$

j is the imaginary unit;

$\delta_U = V_-/V_+$ and $\delta_A = V_0/V_+$ are the degrees of imbalance and asymmetry, respectively, of the phase voltages; and

$\overline{p}, \overline{q}, \overline{z}$ are the orthogonal unit vectors defining the space itself of the imbalance power vector.

According to a second aspect, the present invention also discloses a system for measuring imbalances in an electrical grid, comprising:

- an analysis module, configured for obtaining effective values ($V_{A1}$, $V_{B1}$, $V_{C1}$) and arguments ($\alpha_{A1}$, $\alpha_{B1}$, $\alpha_{C1}$) of the phase voltages at the fundamental frequency, as well as effective values ($I_{A1}$, $I_{B1}$, $I_{C1}$) and arguments ($\beta_{A1}$, $\beta_{B1}$,

$\beta_{C1}$) of the phase currents at the fundamental frequency of the electrical grid;

- a symmetrical module, configured for obtaining the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_o = V_{A1o}$);

- an active and reactive power module, configured for obtaining the active power ($P_{A1}$, $P_{B1}$, $P_{C1}$) and reactive power ($\overline{Q}_{A1}$, $\overline{Q}_{B1}$, $\overline{Q}_{C1}$) of each of the phases at the fundamental frequency;

- an imbalance power vector module, configured for calculating the value of the imbalance power vector ($\overline{S}_u$) according to the following equation:

$$\overline{S}_u = V_+ \sqrt{2 + 2\delta_u^2 + 2\delta_A^2} \cdot \left( \left| \begin{array}{l} \frac{P_{A1}}{V_{A1}} \cos(\alpha_+ - \alpha_{A1}) + j\frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \\ + j\, a^2 \frac{\overline{Q}_{B1}}{V_{B1}} \sin(\alpha_+ - \alpha_{B1}) + a\frac{P_{C1}}{V_{C1}} \cos(\alpha_+ - \alpha_{C1}) + j\, a\frac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\frac{P_{A1}}{V_{A1}} \sin(\alpha_+ - \alpha_{A1}) + \frac{\overline{Q}_{A1}}{V_{A1}} \cos(\alpha_+ - \alpha_{A1}) + j\, a^2 \frac{P_{B1}}{V_{B1}} \sin(\alpha_+ - \alpha_{B1}) + \\ + a^2 \frac{\overline{Q}_{B1}}{V_{B1}} \cos(\alpha_+ - \alpha_{B1}) + j\, a\frac{P_{C1}}{V_{C1}} \sin(\alpha_+ - \alpha_{C1}) + a\frac{\overline{Q}_{C1}}{V_{C1}} \cos(\alpha_+ - \alpha_{C1}) \end{array} \right| \cdot \overline{q} \right) +$$

$$+ V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

wherein

$$a = 1 \angle 120^\circ ;$$

j is the imaginary unit;
$\delta_U = V_-/V_+$ and $\delta_A = V_0/V_+$ are the degrees of imbalance and asymmetry, respectively, of the phase voltages; and $\overline{p}, \overline{q}, \overline{z}$ are the orthogonal unit vectors defining the space itself of the imbalance power vector; and

- an information module, configured for providing information about the calculated value of the imbalance power vector.

Therefore, the present invention provides a method and system for measuring imbalances in an electrical grid, based on the calculation of a new magnitude referred to as "imbalance power vector," as will be defined herein below. The imbalance power vector provides information about imbalances produced in an electrical grid due to effects of both load and voltage imbalances that is more precise than what was made available up until now in the prior art.
As a result of the information provided by means of the imbalance power vector, the method and system of the present invention will be very useful in a wide range of specific applications, such as for example measuring instruments, protection instruments, machine regulating equipment, active filters, electric machine maintenance, etc.

BRIEF DESCRIPTION OF THE DRAWINGS

The present invention will be better understood in reference to the following drawings illustrating preferred embodiments of the invention, provided by way of example, and not to be interpreted as limiting the invention in any way.

Figure 1 is a diagram that graphically depicts the imbalance power vector and its components in the space defined by the coordinate axes ($\overline{p}, \overline{q}, \overline{z}$).
Figure 2 is a block diagram depicting the imbalance power vector and the relationship with its different components.
Figure 3 is a block diagram showing the operational sequence of a method according to the preferred embodiment of the present invention.
Figure 4 schematically shows a system for measuring according to the preferred embodiment of the present invention.
Figure 5 schematically shows an electrical circuit by way of example in which the system for measuring according to the preferred embodiment of the present invention is applied.

DETAILED DISCLOSURE OF PREFERRED EMBODIMENTS

The method and system for measuring disclosed in the present invention are based on the calculation of a magnitude herein referred to as "imbalance power vector" ($\overline{S}_u$). It is of a vector magnitude, i.e., it is defined in a three-dimensional space and has modulus, direction and sense. The modulus is always equal to the value of the imbalance power $S_u$, in systems with both balanced voltages and unbalanced voltages.

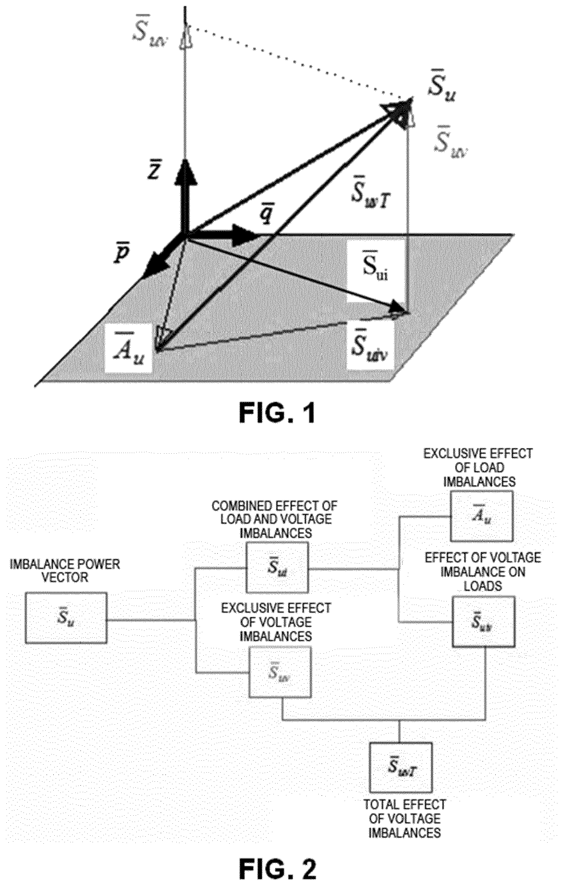

Figures 1 and 2 depict a graphic representation and block diagram representation, respectively, of the imbalance power vector and the relationships with its various components.

From the viewpoint of practical usefulness, two main components of the imbalance power vector: $\overline{S}_{ui}$ and $\overline{S}_{uv}$, are distinguished first. The first component, $\overline{S}_{ui}$, measures the exclusive effects of load imbalances ($\overline{S}_{ui}^b$) together with the effects originated thereon by voltage imbalances ($\overline{S}_{uiv}$); this component of the imbalance power vector is represented in the plane defined by coordinate axes $\overline{p}, \overline{q}$. Therefore, plane $(\overline{p}, \overline{q})$ constitutes the joint domain of load and voltage imbalances. The second component, $\overline{S}_{uv}$, of the imbalance power vector determines the exclusive effect of voltage imbalances and is represented on axis $\overline{z}$ (domain of voltage imbalances), orthogonal to plane $(\overline{p}, \overline{q})$.

It must be noted that the component $\overline{S}_{ui}^b$ coincides with the imbalance power phasor ($\overline{A}_u$) of the prior art, a magnitude which measures the exclusive effects of load imbalances, given that superscript b indicates that voltages are balanced and therefore there is no effect of voltage imbalance.

Finally, vector $\overline{S}_{uvT}$, the vector sum of $\overline{S}_{uiv}$ and $\overline{S}_{uv}$, defines the total effect of voltage imbalances on the electrical grid being studied.

The imbalance power vector and its components allow obtaining quality factors offering information about the effects of imbalances on electrical grids, assessing the exclusive load imbalance or the exclusive voltage imbalance with respect to the total imbalance of the system, as well as the relative importance of resistive and reactive load imbalances, among others.

Likewise, the total imbalance power in an electrical system or grid can be obtained as the modulus of the vector resulting from the vector sum of the imbalance power vectors of each of the integrating parts thereof.

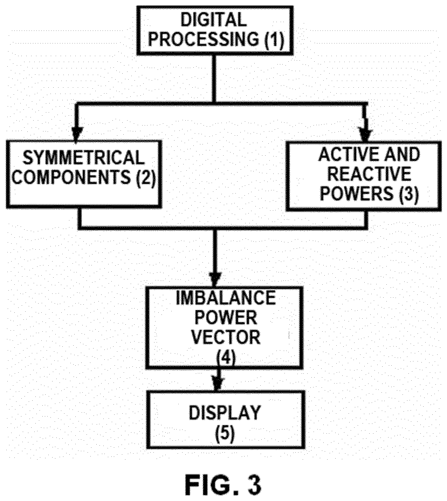

Now turning to Figure 3, a block diagram depicting a method according to the preferred embodiment of the present invention is shown, comprising the steps of:

- Step (1): Digitally processing sampled signals obtained by means of a physical system for measuring and acquiring electrical signals, the matrices of effective values ($V_{A1}$, $V_{B1}$, $V_{C1}$) and arguments ($\alpha_{A1}$, $\alpha_{B1}$, $\alpha_{C1}$) of the voltage at the fundamental frequency for each phase, as well as the matrices of effective values ($I_{A1}$, $I_{B1}$, $I_{C1}$) and arguments ($\beta_{A1}$, $\beta_{B1}$, $\beta_{C1}$) of the current at the fundamental frequency for each phase thereby being obtained.

- Step (2): The symmetrical components, i.e., the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_o = V_{A1o}$) are obtained from the matrices obtained in step (1).

- Step (3): In parallel to step (2), the active power ($P_{A1}$, $P_{B1}$, $P_{C1}$) and reactive power ($\overline{Q}_{A1}$, $\overline{Q}_{B1}$, $\overline{Q}_{C1}$) are obtained from the matrices obtained in step (1) as the real part (Re) and imaginary part (Im), respectively, of the complex powers of each phase:

$$P_{A1} = \mathrm{Re}\left[\overline{V}_{A1} \cdot \overline{I}_{A1}^*\right] \qquad \overline{Q}_{A1} = \mathrm{Im}\left[\overline{V}_{A1} \cdot \overline{I}_{A1}^*\right]$$

$$P_{B1} = \mathrm{Re}\left[\overline{V}_{B1} \cdot \overline{I}_{B1}^*\right] \qquad \overline{Q}_{B1} = \mathrm{Im}\left[\overline{V}_{B1} \cdot \overline{I}_{B1}^*\right]$$

$$P_{C1} = \mathrm{Re}\left[\overline{V}_{C1} \cdot \overline{I}_{C1}^*\right] \qquad \overline{Q}_{C1} = \mathrm{Im}\left[\overline{V}_{C1} \cdot \overline{I}_{C1}^*\right]$$

- Step (4): The imbalance power vector ($\overline{S}_u$), and its various components ($\overline{S}_{ui}$, $\overline{S}_{uv}$) are obtained from the active and reactive powers obtained in step (3) as well as from the symmetrical components obtained in step (2), according to the following expressions:

$$\overline{S}_u = V_+ \sqrt{2 + 2\delta_u^2 + 2\delta_A^2} \cdot \left( \left| \begin{array}{l} \dfrac{P_{A1}}{V_{A1}} \cos(\alpha_+ - \alpha_{A1}) + j \dfrac{\overline{Q}_{A1}}{V_{A1}} \sin(\alpha_+ - \alpha_1) + a^2 \dfrac{P_{B1}}{V_{B1}} \cos(\alpha_+ - \alpha_{B1}) + \\ + j\, a^2 \dfrac{\overline{Q}_{B1}}{V_{B1}} \sin(\alpha_+ - \alpha_{B1}) + a \dfrac{P_{C1}}{V_{C1}} \cos(\alpha_+ - \alpha_{C1}) + j\, a \dfrac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j \dfrac{P_{A1}}{V_{A1}} \sin(\alpha_+ - \alpha_{A1}) + \dfrac{\overline{Q}_{A1}}{V_{A1}} \cos(\alpha_+ - \alpha_{A1}) + j\, a^2 \dfrac{P_{B1}}{V_{B1}} \sin(\alpha_+ - \alpha_{B1}) + \\ + a^2 \dfrac{\overline{Q}_{B1}}{V_{B1}} \cos(\alpha_+ - \alpha_{B1}) + j\, a \dfrac{P_{C1}}{V_{C1}} \sin(\alpha_+ - \alpha_{C1}) + a \dfrac{\overline{Q}_{C1}}{V_{C1}} \cos(\alpha_+ - \alpha_{C1}) \end{array} \right| \cdot \overline{q} \right) +$$

$$+ V_+ \sqrt{\delta_u^2 + \delta_A^2} \cdot \left| \sum_{x=A,B,C} \left( \dfrac{P_{x1}}{V_{x1}} \cos(\alpha_+ - \alpha_{x1}) + j \dfrac{\overline{Q}_{x1}}{V_{x1}} \sin(\alpha_+ - \alpha_{x1}) + j \dfrac{P_{x1}}{V_{x1}} \sin(\alpha_+ - \alpha_{x1}) + \dfrac{\overline{Q}_{x1}}{V_{x1}} \cos(\alpha_+ - \alpha_{x1}) \right) \right| \cdot \overline{z}$$

$$\overline{S}_{ui} = V_+ \sqrt{2 + 2\delta_u^2 + 2\delta_A^2} \cdot \left( \left| \begin{array}{l} \dfrac{P_{A1}}{V_{A1}} \cos(\alpha_+ - \alpha_{A1}) + j \dfrac{\overline{Q}_{A1}}{V_{A1}} \sin(\alpha_+ - \alpha_1) + a^2 \dfrac{P_{B1}}{V_{B1}} \cos(\alpha_+ - \alpha_{B1}) + \\ + j\, a^2 \dfrac{\overline{Q}_{B1}}{V_{B1}} \sin(\alpha_+ - \alpha_{B1}) + a \dfrac{P_{C1}}{V_{C1}} \cos(\alpha_+ - \alpha_{C1}) + j\, a \dfrac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j \dfrac{P_{A1}}{V_{A1}} \sin(\alpha_+ - \alpha_{A1}) + \dfrac{\overline{Q}_{A1}}{V_{A1}} \cos(\alpha_+ - \alpha_{A1}) + j\, a^2 \dfrac{P_{B1}}{V_{B1}} \sin(\alpha_+ - \alpha_{B1}) + \\ + a^2 \dfrac{\overline{Q}_{B1}}{V_{B1}} \cos(\alpha_+ - \alpha_{B1}) + j\, a \dfrac{P_{C1}}{V_{C1}} \sin(\alpha_+ - \alpha_{C1}) + a \dfrac{\overline{Q}_{C1}}{V_{C1}} \cos(\alpha_+ - \alpha_{C1}) \end{array} \right| \cdot \overline{q} \right)$$

$$\overline{S}_{uv} = V_+ \sqrt{\delta_u^2 + \delta_A^2} \cdot \left| \sum_{x=A,B,C} \left( \dfrac{P_{x1}}{V_{x1}} \cos(\alpha_+ - \alpha_{x1}) + j \dfrac{\overline{Q}_{x1}}{V_{x1}} \sin(\alpha_+ - \alpha_{x1}) + j \dfrac{P_{x1}}{V_{x1}} \sin(\alpha_+ - \alpha_{x1}) + \dfrac{\overline{Q}_{x1}}{V_{x1}} \cos(\alpha_+ - \alpha_{x1}) \right) \right| \cdot \overline{z}$$

- Step (5): Finally, graphic and numerical information about the imbalance power vector, as well as values of the physical magnitudes used during the method if desired, is visually depicted on a suitable display device.

According to the preferred embodiment of the present invention, in step (1) the electrical signals acquired by means of the physical system for measuring are the instantaneous values of voltage ($v_A$, $v_B$, $v_C$) and intensity ($i_A$, $i_B$, $i_C$) of the phases (A, B, C) at the point of the electrical grid where the measurement is being taken. Digital processing in turn consists of separating their components at the fundamental frequency ($v_{A1}$, $v_{B1}$, $v_{C1}$), ($i_{A1}$, $i_{B1}$, $i_{C1}$).

According to an additional preferred embodiment of the present invention, the method comprises, in addition to or instead of step (5) of displaying described above, a step of emitting an alarm when the calculated value of at least one of the imbalance power vector ($\overline{S}_u$), its component $\overline{S}_{ui}$ and its component $\overline{S}_{uv}$ exceeds a given threshold. The alarm can be of any suitable type in a specific application, for example a visual and/or acoustic alarm. The method thereby warns an operator that a voltage and/or load imbalance that may have serious effects on the electrical grid in question is taking place such that the operator can take the appropriate measures (for example cutting off the power supply to that part of the electrical grid) to protect the circuit and the apparatus connected thereto.

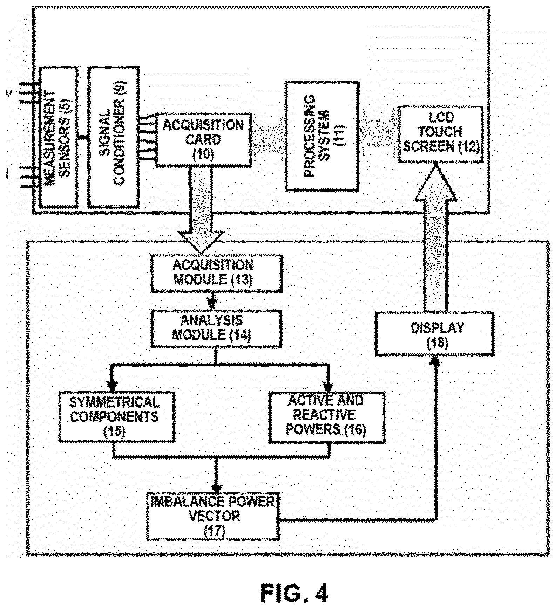

Now turning to Figure 4 attached hereto, an example of a system for measuring according to a preferred embodiment of the present invention is shown. The system comprises voltage and intensity measurement sensors (8) for measuring instantaneous values of voltage and intensity; a signal conditioner (9) for adapting the secondary current of each measurement sensor (8) to the voltage applicable to analog inputs of an acquisition card (10); said acquisition card (10) converting the analog voltage and intensity signals into a series of discrete samples used as input in an acquisition module (13); a processing system (11) with a motherboard in which the acquisition card (10) is placed so that the discrete samples of the voltage and intensity signals can be exchanged with the acquisition module (13); and a touch screen (12) acting as the display device, connected to a display module (18) for visually presenting at least one value calculated by the system for measuring: for example voltages, intensities, active and reactive powers, symmetrical components, imbalance power vector and its components, in modulus and argument form, in addition to the graphic representation thereof.

In addition, the system for measuring according to the preferred embodiment of the present invention also comprises the following modules:

- an acquisition module (13) configured for acquiring the instantaneous values of voltage ($v_A$, $v_C$, $v_C$) and intensity ($i_A$, $i_B$, $i_C$) of the phases (A, B, C) at a point of the electrical grid and separating the components thereof at the fundamental frequency ($v_{A1}$, $v_{B1}$, $v_{C1}$), ($i_{A1}$, $i_{B1}$, $i_{C1}$);

- an analysis module (14) obtaining effective values ($V_{A1}$, $V_{B1}$, $V_{C1}$) and arguments ($\alpha_{A1}$, $\alpha_{B1}$, $\alpha_{C1}$) of the phase voltages at the fundamental frequency, as well as effective values ($I_{A1}$, $I_{B1}$, $I_{C1}$) and arguments ($\beta_{A1}$, $\beta_{B1}$, $\beta_{C1}$) of the phase currents at the fundamental frequency of the electrical grid, from the samples acquired in the preceding module;

- a symmetrical module (15) obtaining the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_o = V_{A1o}$) from the results of the preceding module;

- an active and reactive power module (16) in charge of obtaining the active power ($P_{A1}$, $P_{B1}$, $P_{C1}$) and reactive power ($\overline{Q}_{A1}$, $\overline{Q}_{B1}$, $\overline{Q}_{C1}$) of each of the phases at the fundamental frequency for each type of topology of the electrical installation;

- an imbalance power vector module (17) in charge of obtaining the value of the imbalance power vector ($\overline{S}_u$) and its components, according to the following equations:

$$\overline{S}_u = V_+ \sqrt{2 + 2\delta_u^2 + 2\delta_A^2} \cdot \left| \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\ + ja^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + ja\dfrac{\overline{Q}_{C1}}{V_{C1}}\sin(\alpha_+ - \alpha_{C1}) \end{array} \right| \cdot \overline{p} \right) + \right.$$

$$+ V_+ \sqrt{2 + 2\delta_u^2 + 2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + ja^2\dfrac{P_{B1}}{V_{B1}}\sin(\alpha_+ - \alpha_{B1}) + \\ + a^2\dfrac{\overline{Q}_{B1}}{V_{B1}}\cos(\alpha_+ - \alpha_{B1}) + ja\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right) +$$

$$+ V_+ \sqrt{\delta_u^2 + \delta_A^2} \cdot \left| \sum_{x=A,B,C} \left( \dfrac{P_{x1}}{V_{x1}}\cos(\alpha_+ - \alpha_{x1}) + j\dfrac{\overline{Q}_{x1}}{V_{x1}}\sin(\alpha_+ - \alpha_{x1}) + j\dfrac{P_{x1}}{V_{x1}}\sin(\alpha_+ - \alpha_{x1}) + \dfrac{\overline{Q}_{x1}}{V_{x1}}\cos(\alpha_+ - \alpha_{x1}) \right) \right| \cdot \overline{z}$$

$$\overline{S}_{ui} = V_+ \sqrt{2 + 2\delta_u^2 + 2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\ + ja^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + ja\dfrac{\overline{Q}_{C1}}{V_{C1}}\sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + ja^2\dfrac{P_{B1}}{V_{B1}}\sin(\alpha_+ - \alpha_{B1}) + \\ + a^2\dfrac{\overline{Q}_{B1}}{V_{B1}}\cos(\alpha_+ - \alpha_{B1}) + ja\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right)$$

$$\overline{S}_{uv} = V_+ \sqrt{\delta_u^2 + \delta_A^2} \cdot \left| \sum_{x=A,B,C} \left( \dfrac{P_{x1}}{V_{x1}}\cos(\alpha_+ - \alpha_{x1}) + j\dfrac{\overline{Q}_{x1}}{V_{x1}}\sin(\alpha_+ - \alpha_{x1}) + j\dfrac{P_{x1}}{V_{x1}}\sin(\alpha_+ - \alpha_{x1}) + \dfrac{\overline{Q}_{x1}}{V_{x1}}\cos(\alpha_+ - \alpha_{x1}) \right) \right| \cdot \overline{z}$$

- a display module (18) in charge of visually depicting on a screen at least the calculated value of the imbalance power vector, and optionally its graphic representation and the values of other physical magnitudes, such as: effective values of voltages and intensities; active and reactive powers for each phase; symmetrical components at the fundamental frequency, etc.

According to an additional embodiment of the present invention, the system comprises, in addition to or instead of the display module (18), an alarm module configured for emitting an alarm when the calculated value of at least one of the imbalance power vector ($\overline{S}_u$), its component $\overline{S}_{ui}$ and its component $\overline{S}_{uv}$ exceeds a given threshold. As mentioned above, this allows notifying an operator that a voltage and/or load imbalance that may have serious effects on the electrical grid is taking place so that the operator may take appropriate measures to protect the circuit and the apparatus connected thereto.

A system for measuring such as the one described herein above is practically useful in a range of specific applications, such as the following in a non-limiting manner, for example:

- Measuring instruments: The use of a system for measuring according to the present invention in a measuring instrument allows separately determining the responsibility pertaining to users and electric companies in the energies put into play by the imbalances, as well as accurately measuring the value of said energies.

- Protection instruments: Protective relays for receivers and electrical installations used today to offset excitation voltage imbalances act by taking into consideration the value of the degree of imbalance of said voltages (relationship between the inverse and direct components of the voltages), without taking into account the magnitude of the energies that emerge due to said imbalances. The result is that when the degree of imbalance of the voltages reaches a given value (for example, 2% for one minute for three-phase electric motors), protective relays used today open the circuit to protect the receiver or the electrical installation, even when the energies put into play are not dangerous. Many receivers and installations therefore stop working on a number of occasions without this being strictly necessary, with the subsequent shutdown and reinstatement costs.

By using a system for measuring according to the present invention in protective relays, it is possible to calculate the energy due to the exclusive effect of voltage imbalances and to evaluate whether dangerous values for the receivers and electrical installations are reached, such that the opening of the circuit and the subsequent disconnection takes place only when the imbalance energy may damage said receivers and installations, inefficient and untimely openings of the circuits thereby being prevented.

- Machine regulating equipment: The system for measuring according to the present invention can be incorporated in an electronic converter of the type normally used in various regulating applications, for example in regulating the speed of three-phase electric motors, controlling DFIG operation in wind turbines, etc. In wind farms, for example, voltage sags can cause very undesirable energetic effects, such as disconnection of the turbines, which is expressly prohibited under the regulations in force. The technologies that are applied today try to keep wind turbine operations running throughout the voltage sag by supplying active energy and reactive energy, without taking the imbalance energy into account. Therefore, when the sag is very unbalanced (one-phase and two-phase voltage sags) these technologies are useless and the turbine must be disconnected to prevent it from being severely damaged.

The system disclosed herein allows accurately measuring energies corresponding to voltage imbalances separately from those caused by load imbalances, therefore providing the information required to act on the control circuit of the DFIG converter, thereby keeping the turbine running and minimizing energies caused by imbalances.

- Active filters: Active filters are used in electrical grids to compensate for the effects of imbalances and harmonic distortions. Active filters existing on the market do not distinguish between imbalance and distortion phenomena, given that they do not allow suitably measuring imbalances. An imbalance is generally considered to exist when the effective values of the line currents have a different value in each phase, even when this difference in values is due to harmonics. The system for measuring according to the present invention allows accurately knowing the causes of the imbalances, and therefore measuring its effects (energies) to effectively compensate for those imbalances.

- Electric machine maintenance: According to another embodiment of the present invention, the system for measuring disclosed herein is applied to electric machine (transformer and motor) maintenance. It is thereby possible to detect if a malfunction of the machine is due to a fault (deterioration of a winding or busbar, for example), or if, in contrast, it occurs due to supply voltage imbalances.

EXAMPLE OF APPLICATION

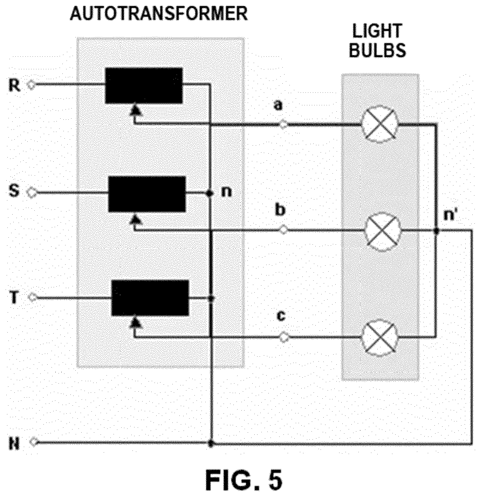

To demonstrate the efficacy of the method and system according to the present invention and the advantages thereof with respect to the prior art, a comparative study between the imbalance power vector ($\overline{S}_u$, present invention) and the imbalance power phasor ($\overline{A}_u$, prior art) was conducted. The electrical circuit shown in Figure 5, in which three 100 W, 230 V incandescent light bulbs were installed was prepared, first supplying them with balanced voltages and then with unbalanced voltages. The supply voltage imbalance was achieved by means of a three-phase phase-variable autotransformer.

A) <u>Balanced voltages:</u>

The three output (secondary) voltages of the autotransformer were adjusted to 115.4 V and the active power (P), the reactive power (Q), the imbalance power phasor ($A_u$) and the imbalance power vector ($S_u$) were recorded in a measuring instrument (digital wattmeter). The results are shown in Table 1 below.

A) <u>Unbalanced voltages:</u>

The output (secondary) voltages of the autotransformer were adjusted until the following values were reached: Van = 100 V, Vbn = 100 V and Vcn = 173.2 V (these voltages have a direct sequence component of 115.4 V, the same value as the balanced voltages in the preceding case). The obtained results are shown in Table 1 below.

Table 1: Power Summary

|  | P (W) | Q (var) | $A_u$ (VA) | $S_u$ (VA) |
|---|---|---|---|---|
| Balanced voltages | 104.29 | 1.00 | 0.902 | 0.902 |
| Unbalanced voltages | 129.83 | 1.32 | 1.18 | 77.445 |

From the results shown in Table 1 above, it can be seen that when balanced voltages were applied to the light bulbs, the primary phenomenon was the active power (P) phenomenon. The reactive power (Q) and imbalance powers ($A_u$, $S_u$) were negligible. The phasor ($A_u$) and the imbalance power vector ($S_u$) were also seen to have the same very minor values, although they are not quite nil due to the small imbalance of the light bulbs caused by small differences between them.

It can also be seen that when unbalanced supply voltages were used, the active power increased by 25.5 W (24.5%) with respect to its value with balanced voltages, whereas the imbalance power phasor ($A_u$) did not detect the change (its value is virtually the same with balanced and unbalanced voltages). However, the imbalance power vector ($S_u$) did in fact detect the effect of the voltage imbalance, given that it went from 0.902 VA to 77.445 VA. This huge increment warns of the increase in active power consumption caused by the voltage imbalance. This effect could not have been detected by the imbalance power phasor ($A_u$).

Therefore, the usefulness and the advantages of the method of the present invention based on the imbalance power vector ($S_u$) (magnitude introduced by the present invention) with respect to the prior art based on the imbalance power phasor ($A_u$) are demonstrated.

Although the present invention has been described above in reference to specific embodiments thereof, the skilled person will understand that modifications and variations can be made without departing from the scope of the present invention as defined in the appended claims. For example, the skilled person may conceive of applications in addition to those mentioned hereinabove, in which the method and system for measuring electrical imbalances of the present invention can be applied.

In addition, although preferred embodiments have been described for both the method and the system for measuring of the present invention in which the value of the imbalance power vector ($\overline{S}_u$) and that of its components ($\overline{S}_{ui}$, $\overline{S}_{uv}$) are calculated, it must be understood that only the imbalance power vector ($\overline{S}_u$) is calculated in other possible embodiments of the present invention.

**Claims**

**1.** A method for measuring imbalances in an electrical grid, comprising the steps of:

i) obtaining effective values ($V_{A1}$, $V_{B1}$, $V_{C1}$) and arguments ($\alpha_{A1}$, $\alpha_{B1}$, $\alpha_{C1}$) of the phase voltages at the fundamental frequency, as well as effective values ($I_{A1}$, $I_{B1}$, $I_{C1}$) and arguments ($\beta_{A1}$, $\beta_{B1}$, $\beta_{C1}$) of the phase currents at the fundamental frequency of the electrical grid;

ii) calculating the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_0 = V_{A1o}$);

iii) determining the active power ($P_{A1}$, $P_{B1}$, $P_{C1}$) and reactive power ($\overline{Q}_{A1}$, $\overline{Q}_{B1}$, $\overline{Q}_{C1}$) of each of the phases at the fundamental frequency from the values of the voltages and currents at the fundamental frequency; and

iv) calculating the value of the imbalance power vector ($\overline{S}_u$) according to the following equation:

$$\overline{S}_u = V_+ \sqrt{2 + 2\delta_u^2 + 2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\[2mm] + j\,a^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + j\,a\dfrac{\overline{Q}_{C1}}{V_{C1}}\sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + j\,a^2\dfrac{P_{B1}}{V_{B1}}\sin(\alpha_+ - \alpha_{B1}) + \\[2mm] + a^2\dfrac{\overline{Q}_{B1}}{V_{B1}}\cos(\alpha_+ - \alpha_{B1}) + j\,a\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right) +$$

$$+ V_+ \sqrt{\delta_u^2 + \delta_A^2} \cdot \left| \sum_{x=A,B,C} \left( \dfrac{P_{x1}}{V_{x1}}\cos(\alpha_+ - \alpha_{x1}) + j\dfrac{\overline{Q}_{x1}}{V_{x1}}\sin(\alpha_+ - \alpha_{x1}) + j\dfrac{P_{x1}}{V_{x1}}\sin(\alpha_+ - \alpha_{x1}) + \dfrac{\overline{Q}_{x1}}{V_{x1}}\cos(\alpha_+ - \alpha_{x1}) \right) \right| \cdot \overline{z}$$

wherein

$$a = 1\angle 120^\circ\,;$$

j is the imaginary unit;

$\delta_U = V_-/V_+$ and $\delta_A = V_0/V_+$ are the degrees of imbalance and asymmetry, respectively, of the phase voltages; and

$\overline{p}, \overline{q}, \overline{z}$ are the orthogonal unit vectors defining the space itself of the imbalance power vector.

2. The method according to claim 1, **characterized in that** it further comprises an initial step of acquiring instantaneous values of voltage ($v_A$, $v_B$, $v_C$) and intensity ($i_A$, $i_B$, $i_C$) of the phases (A, B, C) at a point of the electrical grid and separating the components thereof at the fundamental frequency ($v_{A1}$, $v_{B1}$, $v_{C1}$), ($i_{A1}$, $i_{B1}$, $i_{C1}$), said values being used in step i) for obtaining the effective values and arguments of the phase voltages and currents at the fundamental frequency of the electrical grid.

3. The method according to any of the preceding claims, **characterized in that** it further comprises a step of calculating a component ($\overline{S}_{ui}$) of the imbalance power vector determining the combined effects of voltage and load imbalances according to the following expression:

$$\overline{S}_{ui} = V_+ \sqrt{2 + 2\delta_u^2 + 2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\[2mm] + j\,a^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + j\,a\dfrac{\overline{Q}_{C1}}{V_{C1}}\sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + j\,a^2\dfrac{P_{B1}}{V_{B1}}\sin(\alpha_+ - \alpha_{B1}) + \\[2mm] + a^2\dfrac{\overline{Q}_{B1}}{V_{B1}}\cos(\alpha_+ - \alpha_{B1}) + j\,a\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right)$$

4. The method according to any of the preceding claims, **characterized in that** it further comprises a step of calculating a component ($\overline{S}_{uv}$) of the imbalance power vector determining the exclusive effect of voltage imbalances according to the following equation:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j \frac{\overline{Q}_{x1}}{V_{x1}} \sin(\alpha_+ - \alpha_{x1}) + j \frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**5.** The method according to any of claims 1 and 2, **characterized in that** it further comprises:

- a step of calculating a component ($\overline{S}_{ui}$) of the imbalance power vector determining the combined effects of voltage and load imbalances according to the following expression:

$$\overline{S}_{ui} = V_+ \sqrt{2 + 2\delta_u^2 + 2\delta_A^2} \cdot \left( \left| \begin{array}{l} \frac{P_{A1}}{V_{A1}} \cos(\alpha_+ - \alpha_{A1}) + j \frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \\ + j a^2 \frac{\overline{Q}_{B1}}{V_{B1}} \sin(\alpha_+ - \alpha_{B1}) + a \frac{P_{C1}}{V_{C1}} \cos(\alpha_+ - \alpha_{C1}) + j a \frac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j \frac{P_{A1}}{V_{A1}} \sin(\alpha_+ - \alpha_{A1}) + \frac{\overline{Q}_{A1}}{V_{A1}} \cos(\alpha_+ - \alpha_{A1}) + j a^2 \frac{P_{B1}}{V_{B1}} \sin(\alpha_+ - \alpha_{B1}) + \\ + a^2 \frac{\overline{Q}_{B1}}{V_{B1}} \cos(\alpha_+ - \alpha_{B1}) + j a \frac{P_{C1}}{V_{C1}} \sin(\alpha_+ - \alpha_{C1}) + a \frac{\overline{Q}_{C1}}{V_{C1}} \cos(\alpha_+ - \alpha_{C1}) \end{array} \right| \cdot \overline{q} \right)$$

- a step of calculating a component ($\overline{S}_{uv}$) of the imbalance power vector determining the exclusive effect of voltage imbalances according to the following equation:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j \frac{\overline{Q}_{x1}}{V_{x1}} \sin(\alpha_+ - \alpha_{x1}) + j \frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**6.** The method according to claim 5, **characterized in that** it further comprises a step of visually presenting the calculated value of at least one of the imbalance power vector ($\overline{S}_u$), its component $\overline{S}_{ui}$ and its component $\overline{S}_{uv}$.

**7.** The method according to any of claims 5 and 6, **characterized in that** it further comprises a step of emitting an alarm when the calculated value of at least one of the imbalance power vector ($\overline{S}_u$), its component $\overline{S}_{ui}$ and its component $\overline{S}_{uv}$ exceeds a given threshold.

**8.** A system for measuring imbalances in an electrical grid, comprising:

- an analysis module (14), configured for obtaining effective values ($V_{A1}$, $V_{B1}$, $V_{C1}$) and arguments ($\alpha_{A1}$, $\alpha_{B1}$, $\alpha_{C1}$) of the phase voltages at the fundamental frequency, as well as effective values ($I_{A1}$, $I_{B1}$, $I_{C1}$) and arguments ($\beta_{A1}$, $\beta_{B1}$, $\beta_{C1}$) of the phase currents at the fundamental frequency of the electrical grid;
- a symmetrical module (15), configured for obtaining the effective value ($V_+ = V_{A1+}$) and the argument ($\alpha_+ = \alpha_{A1+}$) of the positive sequence voltages and the effective values of the negative sequence voltage ($V_- = V_{A1-}$) and zero sequence voltage ($V_o = V_{A1o}$);
- an active and reactive power module (16), configured for obtaining the active power ($P_{A1}$, $P_{B1}$, $P_{C1}$) and reactive power ($\overline{Q}_{A1}$, $\overline{Q}_{B1}$, $\overline{Q}_{C1}$) of each of the phases at the fundamental frequency;
- an imbalance power vector module (17), configured for calculating the value of the imbalance power vector ($\overline{S}_u$) according to the following equation:

$$\bar{S}_u = V_+ \sqrt{2+2\delta_u^2+2\delta_A^2} \cdot \left| \left( \left| \begin{array}{l} \dfrac{P_{A1}}{V_{A1}}\cos(\alpha_+-\alpha_{A1})+j\dfrac{\overline{Q}_{A1}}{V_{A1}}\sin(\alpha_+-\alpha_1)+a^2\dfrac{P_{B1}}{V_{B1}}\cos(\alpha_+-\alpha_{B1})+ \\ +ja^2\dfrac{\overline{Q}_{B1}}{V_{B1}}\sin(\alpha_+-\alpha_{B1})+a\dfrac{P_{C1}}{V_{C1}}\cos(\alpha_+-\alpha_{C1})+ja\dfrac{\overline{Q}_{C1}}{V_{C1}}\sin(\alpha_+-\alpha_{C1}) \end{array} \right| \right) \cdot \bar{p} \right| +$$

$$+V_+ \sqrt{2+2\delta_u^2+2\delta_A^2} \cdot \left| \left( \left| \begin{array}{l} j\dfrac{P_{A1}}{V_{A1}}\sin(\alpha_+-\alpha_{A1})+\dfrac{\overline{Q}_{A1}}{V_{A1}}\cos(\alpha_+-\alpha_{A1})+ja^2\dfrac{P_{B1}}{V_{B1}}\sin(\alpha_+-\alpha_{B1})+ \\ +a^2\dfrac{\overline{Q}_{B1}}{V_{B1}}\cos(\alpha_+-\alpha_{B1})+ja\dfrac{P_{C1}}{V_{C1}}\sin(\alpha_+-\alpha_{C1})+a\dfrac{\overline{Q}_{C1}}{V_{C1}}\cos(\alpha_+-\alpha_{C1}) \end{array} \right| \right) \cdot \bar{q} \right| +$$

$$+V_+ \sqrt{\delta_u^2+\delta_A^2} \cdot \left| \sum_{x=A,B,C} \left( \dfrac{P_{x1}}{V_{x1}}\cos(\alpha_+-\alpha_{x1})+j\dfrac{\overline{Q}_{x1}}{V_{x1}}\sin(\alpha_+-\alpha_{x1})+j\dfrac{P_{x1}}{V_{x1}}\sin(\alpha_+-\alpha_{x1})+\dfrac{\overline{Q}_{x1}}{V_{x1}}\cos(\alpha_+-\alpha_{x1}) \right) \right| \cdot \bar{z}$$

wherein

$$a = 1\angle 120^\circ ;$$

j is the imaginary unit;

$\delta_U = V_-/V_+$ and $\delta_A = V_0/V_+$ are the degrees of imbalance and asymmetry, respectively, of the phase voltages; and

$\overline{p},\overline{q},\overline{z}$ are the orthogonal unit vectors defining the space itself of the imbalance power vector; and

- an information module, configured for providing information about the calculated value of the imbalance power vector.

9. The system according to claim 8, **characterized in that** it further comprises an acquisition module (13) configured for acquiring the instantaneous values of voltage ($v_A$, $v_B$, $v_C$) and intensity ($i_A$, $i_B$, $i_C$) of the phases (A, B, C) at a point of the electrical grid and separating the components thereof at the fundamental frequency ($v_{A1}$, $v_{B1}$, $v_{C1}$), ($i_{A1}$, $i_{B1}$, $i_{C1}$), said values being used by the analysis module (14) for obtaining the effective values and arguments of the phase voltages and currents at the fundamental frequency of the electrical grid.

10. The system according to any of claims 8 and 9, **characterized in that** the imbalance power vector module (17) is further configured for calculating a component ($\overline{S}_{ui}$) of the imbalance power vector determining the combined effects of voltage and load imbalances according to the following expression:

$$\bar{S}_{ui} = V_+ \sqrt{2+2\delta_u^2+2\delta_A^2} \cdot \left| \left( \left| \begin{array}{l} \dfrac{P_{A1}}{V_{A1}}\cos(\alpha_+-\alpha_{A1})+j\dfrac{\overline{Q}_{A1}}{V_{A1}}\sin(\alpha_+-\alpha_1)+a^2\dfrac{P_{B1}}{V_{B1}}\cos(\alpha_+-\alpha_{B1})+ \\ +ja^2\dfrac{\overline{Q}_{B1}}{V_{B1}}\sin(\alpha_+-\alpha_{B1})+a\dfrac{P_{C1}}{V_{C1}}\cos(\alpha_+-\alpha_{C1})+ja\dfrac{\overline{Q}_{C1}}{V_{C1}}\sin(\alpha_+-\alpha_{C1}) \end{array} \right| \right) \cdot \bar{p} \right| +$$

$$+V_+ \sqrt{2+2\delta_u^2+2\delta_A^2} \cdot \left| \left( \left| \begin{array}{l} j\dfrac{P_{A1}}{V_{A1}}\sin(\alpha_+-\alpha_{A1})+\dfrac{\overline{Q}_{A1}}{V_{A1}}\cos(\alpha_+-\alpha_{A1})+ja^2\dfrac{P_{B1}}{V_{B1}}\sin(\alpha_+-\alpha_{B1})+ \\ +a^2\dfrac{\overline{Q}_{B1}}{V_{B1}}\cos(\alpha_+-\alpha_{B1})+ja\dfrac{P_{C1}}{V_{C1}}\sin(\alpha_+-\alpha_{C1})+a\dfrac{\overline{Q}_{C1}}{V_{C1}}\cos(\alpha_+-\alpha_{C1}) \end{array} \right| \right) \cdot \bar{q} \right|$$

11. The system according to any of claims 8 to 10, **characterized in that** the imbalance power vector module (17) is further configured for calculating a component ($\overline{S}_{uv}$) of the imbalance power vector determining the exclusive effect of voltage imbalances according to the following equation:

$$\bar{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \bar{z}$$

**12.** The system according to any of claims 8 and 9, **characterized in that** the imbalance power vector module (17) is further configured for calculating:

- a component ($\overline{S}_{ui}$) of the imbalance power vector determining the combined effects of voltage and load imbalances according to the following expression:

$$\bar{S}_{ui} = V_+ \sqrt{2 + 2\delta_u^2 + 2\delta_A^2} \cdot \left( \left| \begin{array}{l} \frac{P_{A1}}{V_{A1}} \cos(\alpha_+ - \alpha_{A1}) + j\frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \\ + ja^2 \frac{\overline{Q}_{B1}}{V_{B1}} \sin(\alpha_+ - \alpha_{B1}) + a\frac{P_{C1}}{V_{C1}} \cos(\alpha_+ - \alpha_{C1}) + ja\frac{\overline{Q}_{C1}}{V_{C1}} \sin(\alpha_+ - \alpha_{C1}) \end{array} \right| \cdot \bar{p} \right) +$$

$$+ V_+ \sqrt{2 + 2\delta_u^2 + 2\delta_A^2} \cdot \left( \left| \begin{array}{l} j\frac{P_{A1}}{V_{A1}} \sin(\alpha_+ - \alpha_{A1}) + \frac{\overline{Q}_{A1}}{V_{A1}} \cos(\alpha_+ - \alpha_{A1}) + ja^2 \frac{P_{B1}}{V_{B1}} \sin(\alpha_+ - \alpha_{B1}) + \\ + a^2 \frac{\overline{Q}_{B1}}{V_{B1}} \cos(\alpha_+ - \alpha_{B1}) + ja\frac{P_{C1}}{V_{C1}} \sin(\alpha_+ - \alpha_{C1}) + a\frac{\overline{Q}_{C1}}{V_{C1}} \cos(\alpha_+ - \alpha_{C1}) \end{array} \right| \cdot \bar{q} \right)$$

- a component ($\overline{S}_{uv}$) of the imbalance power vector determining the exclusive effect of voltage imbalances according to the following equation:

$$\bar{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \bar{z}$$

**13.** The system according to claim 12, **characterized in that** the information module is a display module (18) configured for visually depicting said information consisting of at least one of the calculated value and the graphic representation of said value of at least one of the calculated value of the imbalance power vector, its component $\overline{S}_{ui}$ and its component $\overline{S}_{uv}$.

**14.** The system according to any of claims 12 and 13, **characterized in that** the information module is an alarm module configured for emitting an alarm when the calculated value of at least one of the imbalance power vector ($\overline{S}_u$), its component $\overline{S}_{ui}$ and its component $\overline{S}_{uv}$ exceeds a given threshold.

**15.** The system according to any of claims 8 to 13, **characterized in that** it further comprises:

- voltage and intensity measurement sensors (8) for measuring the instantaneous values of voltage and intensity;
- a signal conditioner (9) for adapting the secondary current of each measurement sensor (8) to the voltage applicable to analog inputs of an acquisition card (10);
- an acquisition card (10) converting analog signals into a series of discrete samples used as input in the acquisition module (13);
- a processing system (11) connecting the acquisition card (10) with the acquisition module (13); and
- a display device (12) connected with the display module (18) for visually presenting at least one value calculated by the system for measuring.

**Patentansprüche**

**1.** Verfahren zum Messen von Unsymmetrien in einem Stromnetz, umfassend die Schritte:

i) Erhalten von Effektivwerten ($V_{A1}$, $V_{B1}$, $V_{C1}$) und Argumenten ($\alpha_{A1}$, $\alpha_{B1}$, $\alpha_{C1}$) der Phasenspannungen bei der Grundfrequenz sowie Effektivwerten ($I_{A1}$, $I_{B1}$, $I_{C1}$) und Argumenten ($\beta_{A1}$, $\beta_{B1}$, $\beta_{C1}$) der Phasenströme bei der Grundfrequenz des Stromnetzes;

ii) Berechnen des Effektivwertes ($V_+ = V_{A1+}$) und des Arguments ($\alpha_+ = \alpha_{A1}$ +) der Mitsystemspannungen und der Effektivwerte der Gegensystemspannung ($V_- = V_{A1-}$) und der Nullsystemspannung ($V_0 = V_{A1o}$);

iii) Ermitteln der Wirkleistung ($P_{A1}$, $P_{B1}$, $P_{C1}$) und der Blindleistung ($\overline{Q}_{A1}$, $\overline{Q}_{B1}$, $\overline{Q}_{C1}$) jeder der Phasen bei der Grundfrequenz aus den Werten der Spannungen und Ströme bei der Grundfrequenz; und

iv) Berechnung des Wertes des Unsymmetrieleistungsvektors ($\overline{S}_u$) nach folgender Gleichung:

$$
\begin{aligned}
\overline{S}_u ={}& V_+ \sqrt{2+2\delta_u^2+2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\[2mm] + j\,a^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + j\,a\dfrac{\overline{Q}_{C1}}{V_{C1}}\sin(\alpha_+ - \alpha_{C1}) \end{array} \right| \cdot \overline{p} \right) + \\[4mm]
& + V_+ \sqrt{2+2\delta_u^2+2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + j\,a^2\dfrac{P_{B1}}{V_{B1}}\sin(\alpha_+ - \alpha_{B1}) + \\[2mm] + a^2\dfrac{\overline{Q}_{B1}}{V_{B1}}\cos(\alpha_+ - \alpha_{B1}) + j\,a\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right) + \\[4mm]
& + V_+ \sqrt{\delta_u^2+\delta_A^2} \left| \sum_{x=A,B,C} \left( \dfrac{P_{x1}}{V_{x1}}\cos(\alpha_+ - \alpha_{x1}) + j\dfrac{\overline{Q}_{x1}}{V_{x1}}\sin(\alpha_+ - \alpha_{x1}) + j\dfrac{P_{x1}}{V_{x1}}\sin(\alpha_+ - \alpha_{x1}) + \dfrac{\overline{Q}_{x1}}{V_{x1}}\cos(\alpha_+ - \alpha_{x1}) \right) \right| \cdot \overline{z}
\end{aligned}
$$

wobei

$$a = 1\angle 120°;$$

$j$ der Imaginärteil ist;

$\delta_U = V_-/V_+$ und $\delta_A = V_0/V_+$ die Ausmaße von Unsymmetrie bzw. Schieflast der Phasenspannungen sind; und $\overline{p}, \overline{q}, \overline{z}$ die orthogonalen Einheitsvektoren sind, die den Raum selbst des Unsymmetrieleistungsvektors definieren.

2. Verfahren nach Anspruch 1, **dadurch gekennzeichnet, dass** es ferner einen Anfangsschritt zum Erfassen von Momentanwerten von Spannung ($v_A$, $v_B$, $v_C$) und Intensität ($i_A$, $i_B$, $i_C$) der Phasen (A, B, C) an einem Punkt des Stromnetzes und Trennen seiner Komponenten bei der Grundfrequenz ($v_{A1}$, $v_{B1}$, $v_{C1}$), ($i_{A1}$, $i_{B1}$, $i_{C1}$) umfasst, wobei diese Werte in Schritt i) zum Erhalten der Effektivwerte und Argumente der Phasenspannungen und -ströme bei der Grundfrequenz des Stromnetzes verwendet werden.

3. Verfahren nach einem der vorhergehenden Ansprüche, **dadurch gekennzeichnet, dass** es ferner einen Schritt zum Berechnen einer Komponente ($\overline{S}_{ui}$) des Unsymmetrieleistungsvektors umfasst, der die kombinierten Effekte von Spannungs- und Lastunsymmetrien nach folgendem Ausdruck bestimmt:

$$
\begin{aligned}
\overline{S}_{ui} ={}& V_+ \sqrt{2+2\delta_u^2+2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\[2mm] + j\,a^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + j\,a\dfrac{\overline{Q}_{C1}}{V_{C1}}\sin(\alpha_+ - \alpha_{C1}) \end{array} \right| \cdot \overline{p} \right) + \\[4mm]
& + V_+ \sqrt{2+2\delta_u^2+2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + j\,a^2\dfrac{P_{B1}}{V_{B1}}\sin(\alpha_+ - \alpha_{B1}) + \\[2mm] + a^2\dfrac{\overline{Q}_{B1}}{V_{B1}}\cos(\alpha_+ - \alpha_{B1}) + j\,a\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right)
\end{aligned}
$$

4. Verfahren nach einem der vorhergehenden Ansprüche, **dadurch gekennzeichnet, dass** es ferner einen Schritt zum Berechnen einer Komponente ($\overline{S}_{uv}$) des Unsymmetrieleistungsvektors umfasst, der den ausschließlichen Effekt von Spannungsunsymmetrien nach folgender Gleichung bestimmt:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**5.** Verfahren nach einem der Ansprüche 1 und 2, **dadurch gekennzeichnet, dass** es ferner umfasst:

- einen Schritt zum Berechnen einer Komponente ($\overline{S}_{ui}$) des Unsymmetrieleistungsvektors, der die kombinierten Effekte von Spannungs- und Lastunsymmetrien nach folgendem Ausdruck bestimmt:

$$\overline{S}_{ui} = V_+ \sqrt{2 + 2\delta_u^2 + 2\delta_A^2} \cdot \left( \left| \begin{array}{l} \frac{P_{A1}}{V_{A1}} \cos(\alpha_+ - \alpha_{A1}) + j\frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \\ + ja^2 \frac{\overline{Q}_{B1}}{V_{B1}} \sin(\alpha_+ - \alpha_{B1}) + a\frac{P_{C1}}{V_{C1}} \cos(\alpha_+ - \alpha_{C1}) + ja\frac{\overline{Q}_{C1}}{V_{C1}} \sin(\alpha_+ - \alpha_{C1}) \end{array} \right| \cdot \overline{p} \right) +$$

$$+ V_+ \sqrt{2 + 2\delta_u^2 + 2\delta_A^2} \cdot \left( \left| \begin{array}{l} j\frac{P_{A1}}{V_{A1}} \sin(\alpha_+ - \alpha_{A1}) + \frac{\overline{Q}_{A1}}{V_{A1}} \cos(\alpha_+ - \alpha_{A1}) + ja^2 \frac{P_{B1}}{V_{B1}} \sin(\alpha_+ - \alpha_{B1}) + \\ + a^2 \frac{\overline{Q}_{B1}}{V_{B1}} \cos(\alpha_+ - \alpha_{B1}) + ja\frac{P_{C1}}{V_{C1}} \sin(\alpha_+ - \alpha_{C1}) + a\frac{\overline{Q}_{C1}}{V_{C1}} \cos(\alpha_+ - \alpha_{C1}) \end{array} \right| \cdot \overline{q} \right)$$

- einen Schritt zum Berechnen einer Komponente ($\overline{S}_{uv}$) des Unsymmetrieleistungsvektors, der den ausschließlichen Effekt von Spannungsunsymmetrien nach folgender Gleichung bestimmt:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**6.** Verfahren nach Anspruch 5, **dadurch gekennzeichnet, dass** es ferner einen Schritt des visuellen Darstellens des berechneten Wertes von mindestens einem aus Unsymmetrieleistungsvektor ($\overline{S}_u$), seiner Komponente $\overline{S}_{ui}$ und seiner Komponente $\overline{S}_{uv}$ umfasst.

**7.** Verfahren nach einem der Ansprüche 5 und 6, **dadurch gekennzeichnet, dass** es ferner einen Schritt des Ausgebens eines Alarms umfasst, wenn der berechnete Wert von mindestens einem aus Unsymmetrieleistungsvektor ($\overline{S}_u$), seiner Komponente $\overline{S}_{ui}$ und seiner Komponente $\overline{S}_{uv}$ einen vorgegebenen Schwellenwert überschreitet.

**8.** System zum Messen von Unsymmetrien in einem Stromnetz, umfassend:

- ein Analysemodul (14), das zum Erhalten von Effektivwerten ($V_{A1}$, $V_{B1}$, $V_{C1}$) und Argumenten ($\alpha_{A1}$, $\alpha_{B1}$, $\alpha_{C1}$) der Phasenspannungen bei der Grundfrequenz sowie Effektivwerten ($I_{A1}$, $I_{B1}$, $I_{C1}$) und Argumenten ($\beta_{A1}$, $\beta_{B1}$, $\beta_{C1}$) der Phasenströme bei der Grundfrequenz des Stromnetzes ausgelegt ist;
- ein Symmetriemodul (15), das zum Erhalten des Effektivwertes ($V_+ = V_{A1+}$) und des Arguments ($\alpha_+ = \alpha_{A1+}$) der Mitsystemspannungen und der Effektivwerte der Gegensystemspannung ($V_- = V_{A1-}$) und der Nullsystemspannung ($V_o = V_{A1o}$) ausgelegt ist;
- ein Wirk- und Blindleistungsmodul (16), das zum Erhalten der Wirkleistung ($P_{A1}$, $P_{B1}$, $P_{C1}$) und der Blindleistung ($\overline{Q}_{A1}$, $\overline{Q}_{B1}$, $\overline{Q}_{C1}$) jeder der Phasen bei der Grundfrequenz ausgelegt ist;
- ein Unsymmetrieleistungsvektormodul (17), das zum Berechnen des Wertes des Unsymmetrieleistungsvektors ($\overline{S}_u$) nach folgender Gleichung ausgelegt ist:

$$\overline{S}_u = V_+\sqrt{2+2\delta_u^2+2\delta_A^2}\cdot\left(\left|\begin{array}{l}\dfrac{P_{A1}}{V_{A1}}\cos(\alpha_+-\alpha_{A1})+j\dfrac{\overline{Q}_{A1}}{V_{A1}}\sin(\alpha_+-\alpha_1)+a^2\dfrac{P_{B1}}{V_{B1}}\cos(\alpha_+-\alpha_{B1})+\\[2mm]+ja^2\dfrac{\overline{Q}_{B1}}{V_{B1}}\sin(\alpha_+-\alpha_{B1})+a\dfrac{P_{C1}}{V_{C1}}\cos(\alpha_+-\alpha_{C1})+ja\dfrac{Q_{C1}}{V_{C1}}\sin(\alpha_+-\alpha_{C1})\end{array}\right|\cdot\overline{p}\right)+$$

$$+V_+\sqrt{2+2\delta_u^2+2\delta_A^2}\cdot\left(\left|\begin{array}{l}j\dfrac{P_{A1}}{V_{A1}}\sin(\alpha_+-\alpha_{A1})+\dfrac{\overline{Q}_{A1}}{V_{A1}}\cos(\alpha_+-\alpha_{A1})+ja^2\dfrac{P_{B1}}{V_{B1}}\sin(\alpha_+-\alpha_{B1})+\\[2mm]+a^2\dfrac{\overline{Q}_{B1}}{V_{B1}}\cos(\alpha_+-\alpha_{B1})+ja\dfrac{P_{C1}}{V_{C1}}\sin(\alpha_+-\alpha_{C1})+a\dfrac{\overline{Q}_{C1}}{V_{C1}}\cos(\alpha_+-\alpha_{C1})\end{array}\right|\cdot\overline{q}\right)+$$

$$+V_+\sqrt{\delta_u^2+\delta_A^2}\cdot\left|\sum_{x=A,B,C}\left(\dfrac{P_{x1}}{V_{x1}}\cos(\alpha_+-\alpha_{x1})+j\dfrac{\overline{Q}_{x1}}{V_{x1}}\sin(\alpha_+-\alpha_{x1})+j\dfrac{P_{x1}}{V_{x1}}\sin(\alpha_+-\alpha_{x1})+\dfrac{\overline{Q}_{x1}}{V_{x1}}\cos(\alpha_+-\alpha_{x1})\right)\right|\cdot\overline{z}$$

wobei

$$a = 1\angle 120°;$$

j der Imaginärteil ist;

$\delta_U = V_-/V_+$ und $\delta_A = V_0/V_+$ die Ausmaße von Unsymmetrie bzw. Schieflast der Phasenspannungen sind; und $\overline{p},\overline{q},\overline{z}$ die orthogonalen Einheitsvektoren sind, die den Raum selbst des Unsymmetrieleistungsvektors definieren; und

- ein Informationsmodul, das zum Bereitstellen von Informationen über den berechneten Wert des Unsymmetrieleistungsvektors ausgelegt ist.

9. System nach Anspruch 8, **dadurch gekennzeichnet, dass** es ferner ein Erfassungsmodul (13) zum Erfassen der Momentanwerte von Spannung ($v_A$, $v_B$, $v_C$) und Intensität ($i_A$, $i_B$, $i_C$) der Phasen (A, B, C) an einem Punkt des Stromnetzes und Trennen seiner Komponenten bei der Grundfrequenz ($v_{A1}$, $v_{B1}$, $v_{C1}$), ($i_{A1}$, $i_{B1}$, $i_{C1}$) umfasst, wobei diese Werte durch das Analysemodul (14) zum Erhalten der Effektivwerte und Argumente der Phasenspannungen und -ströme bei der Grundfrequenz des Stromnetzes verwendet werden.

10. System nach einem der Ansprüche 8 und 9, **dadurch gekennzeichnet, dass** das Unsymmetrieleistungsvektormodul (17) ferner zum Berechnen einer Komponente ($\overline{S}_{ui}$) des Unsymmetrieleistungsvektors ausgelegt ist, der die kombinierten Effekte von Spannungs- und Lastunsymmetrien nach folgendem Ausdruck bestimmt:

$$\overline{S}_{ui} = V_+\sqrt{2+2\delta_u^2+2\delta_A^2}\cdot\left(\left|\begin{array}{l}\dfrac{P_{A1}}{V_{A1}}\cos(\alpha_+-\alpha_{A1})+j\dfrac{\overline{Q}_{A1}}{V_{A1}}\sin(\alpha_+-\alpha_1)+a^2\dfrac{P_{B1}}{V_{B1}}\cos(\alpha_+-\alpha_{B1})+\\[2mm]+ja^2\dfrac{\overline{Q}_{B1}}{V_{B1}}\sin(\alpha_+-\alpha_{B1})+a\dfrac{P_{C1}}{V_{C1}}\cos(\alpha_+-\alpha_{C1})+ja\dfrac{Q_{C1}}{V_{C1}}\sin(\alpha_+-\alpha_{C1})\end{array}\right|\cdot\overline{p}\right)+$$

$$+V_+\sqrt{2+2\delta_u^2+2\delta_A^2}\cdot\left(\left|\begin{array}{l}j\dfrac{P_{A1}}{V_{A1}}\sin(\alpha_+-\alpha_{A1})+\dfrac{\overline{Q}_{A1}}{V_{A1}}\cos(\alpha_+-\alpha_{A1})+ja^2\dfrac{P_{B1}}{V_{B1}}\sin(\alpha_+-\alpha_{B1})+\\[2mm]+a^2\dfrac{\overline{Q}_{B1}}{V_{B1}}\cos(\alpha_+-\alpha_{B1})+ja\dfrac{P_{C1}}{V_{C1}}\sin(\alpha_+-\alpha_{C1})+a\dfrac{\overline{Q}_{C1}}{V_{C1}}\cos(\alpha_+-\alpha_{C1})\end{array}\right|\cdot\overline{q}\right)$$

11. System nach einem der Ansprüche 8 bis 10, **dadurch gekennzeichnet, dass** das Unsymmetrieleistungsvektormodul (17) ferner zum Berechnen einer Komponente ($\overline{S}_{uv}$) des Unsymmetrieleistungsvektor ausgelegt ist, der den ausschließlichen Effekt von Spannungsunsymmetrien nach folgender Gleichung bestimmt:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**12.** System nach einem der Ansprüche 8 und 9, **dadurch gekennzeichnet, dass** das Unsymmetrieleistungsvektormodul (17) ferner ausgelegt ist zum Berechnen:

- einer Komponente ($\overline{S}_{ui}$) des Unsymmetrieleistungsvektors, der die kombinierten Effekte von Spannungs- und Lastunsymmetrien nach folgendem Ausdruck bestimmt:

$$\overline{S}_{ui} = V_+ \sqrt{2 + 2\delta_u^2 + 2\delta_A^2} \cdot \left( \left| \frac{P_{A1}}{V_{A1}} \cos(\alpha_+ - \alpha_{A1}) + j\frac{\overline{Q}_{A1}}{V_{A1}} \sin(\alpha_+ - \alpha_1) + a^2 \frac{P_{B1}}{V_{B1}} \cos(\alpha_+ - \alpha_{B1}) + \right. \right. \\ \left. \left. + ja^2 \frac{\overline{Q}_{B1}}{V_{B1}} \sin(\alpha_+ - \alpha_{B1}) + a\frac{P_{C1}}{V_{C1}} \cos(\alpha_+ - \alpha_{C1}) + ja\frac{\overline{Q}_{C1}}{V_{C1}} \sin(\alpha_+ - \alpha_{C1}) \right| \right) \cdot \overline{p} +$$

$$+ V_+ \sqrt{2 + 2\delta_u^2 + 2\delta_A^2} \cdot \left( \left| j\frac{P_{A1}}{V_{A1}} \sin(\alpha_+ - \alpha_{A1}) + \frac{\overline{Q}_{A1}}{V_{A1}} \cos(\alpha_+ - \alpha_{A1}) + ja^2 \frac{P_{B1}}{V_{B1}} \sin(\alpha_+ - \alpha_{B1}) + \right. \right. \\ \left. \left. + a^2 \frac{\overline{Q}_{B1}}{V_{B1}} \cos(\alpha_+ - \alpha_{B1}) + ja\frac{P_{C1}}{V_{C1}} \sin(\alpha_+ - \alpha_{C1}) + a\frac{\overline{Q}_{C1}}{V_{C1}} \cos(\alpha_+ - \alpha_{C1}) \right| \right) \cdot \overline{q}$$

- einer Komponente ($\overline{S}_{uv}$) des Unsymmetrieleistungsvektors, der den ausschließlichen Effekt von Spannungsunsymmetrien nach folgender Gleichung bestimmt:

$$\overline{S}_{uv} = V_+ \sqrt{\delta_u^2 + \delta_A^2} \cdot \left| \sum_{x=A,B,C} \left( \frac{P_{x1}}{V_{x1}} \cos(\alpha_+ - \alpha_{x1}) + j\frac{\overline{Q}_{x1}}{V_{x1}} \sin(\alpha_+ - \alpha_{x1}) + j\frac{P_{x1}}{V_{x1}} \sin(\alpha_+ - \alpha_{x1}) + \frac{\overline{Q}_{x1}}{V_{x1}} \cos(\alpha_+ - \alpha_{x1}) \right) \right| \cdot \overline{z}$$

**13.** System nach Anspruch 12, **dadurch gekennzeichnet, dass** das Informationsmodul ein Anzeigemodul (18) ist, das zum visuellen Darstellen der Informationen ausgelegt ist, die aus mindestens einem aus dem berechneten Wert und der grafischen Darstellung des Wertes von mindestens einem aus dem berechneten Wert des Unsymmetrieleistungsvektors, seiner Komponente $\overline{S}_{ui}$ und seiner Komponente $\overline{S}_{uv}$ bestehen.

**14.** System nach einem der Ansprüche 12 und 13, **dadurch gekennzeichnet, dass** das Informationsmodul ein Alarmmodul ist, das zum Ausgeben eines Alarms ausgelegt ist, wenn der berechnete Wert von mindestens einem aus Unsymmetrieleistungsvektor($\overline{S}_u$), seiner Komponente $\overline{S}_{ui}$ und seiner Komponente $\overline{S}_{uv}$ einen vorgegebenen Schwellenwert überschreitet.

**15.** System nach einem der Ansprüche 8 bis 13, **dadurch gekennzeichnet, dass** es ferner umfasst:

- Spannungs- und Intensitätsmesssensoren (8) zum Messen der Momentanwerte von Spannung und Intensität;
- eine Signalaufbereitungseinrichtung (9) zum Anpassen des Sekundärstroms jedes Messsensors (8) an die an analogen Eingängen einer Erfassungskarte (10) anzulegende Spannung;
- eine Erfassungskarte (10), die analoge Signale in eine Reihe von diskreten Abtastwerten umwandelt, die als Eingang in das Erfassungsmodul (13) verwendet werden;
- ein Verarbeitungssystem (11), das die Erfassungskarte (10) mit dem Erfassungsmodul (13) verbindet; und
- eine Anzeigevorrichtung (12), die mit dem Anzeigemodul (18) verbunden ist, um mindestens einen durch das Messsystem berechneten Wert visuell darzustellen.

**Revendications**

1. Méthode de mesure de déséquilibres sur un réseau électrique, comprenant les étapes suivantes :

   i) obtention de valeurs effectives ($V_{A1}$, $V_{B1}$, $V_{C1}$) et d'arguments ($\alpha_{A1}$, $\alpha_{B1}$, $\alpha_{C1}$) des tensions de phase à la fréquence fondamentale, ainsi que de valeurs effectives ($I_{A1}$, $I_{B1}$, $I_{C1}$) et d'arguments ($\beta_{A1}$, $\beta_{B1}$, $\beta_{C1}$) des courants de phase à la fréquence fondamentale du réseau électrique ;
   ii) calcul de la valeur effective ($V_+ = V_{A1+}$) et de l'argument ($\alpha_+ = \alpha_{A1+}$) des tensions de séquence positives et des valeurs effectives de la tension de séquence négative ($V_- = V_{A1-}$) et de la tension de séquence zéro ($V_o = V_{A1o}$);
   iii) détermination de la puissance active ($P_{A1}$, $P_{B1}$, $P_{C1}$) et de la puissance réactive ($\overline{Q}_{A1}$, $\overline{Q}_{B1}$, $\overline{Q}_{C1}$) de chacune des phases à la fréquence fondamentale à partir des valeurs des tensions et des courants à la fréquence fondamentale ; et
   iv) calcul de la valeur du vecteur de puissance de déséquilibre ($\overline{S}_u$) selon l'équation suivante :

$$\overline{S}_u = V_+ \sqrt{2+2\delta_u^2+2\delta_A^2} \cdot \left( \left| \frac{P_{A1}}{V_{A1}}\cos(\alpha_+-\alpha_{A1}) + j\frac{\overline{Q}_{A1}}{V_{A1}}\sin(\alpha_+-\alpha_1) + a^2\frac{P_{B1}}{V_{B1}}\cos(\alpha_+-\alpha_{B1}) + \atop +ja^2\frac{\overline{Q}_{B1}}{V_{B1}}\sin(\alpha_+-\alpha_{B1}) + a\frac{P_{C1}}{V_{C1}}\cos(\alpha_+-\alpha_{C1}) + ja\frac{\overline{Q}_{C1}}{V_{C1}}\sin(\alpha_+-\alpha_{C1}) \right| \cdot \overline{p} \right) +$$

$$+ V_+ \sqrt{2+2\delta_u^2+2\delta_A^2} \cdot \left( \left| j\frac{P_{A1}}{V_{A1}}\sin(\alpha_+-\alpha_{A1}) + \frac{\overline{Q}_{A1}}{V_{A1}}\cos(\alpha_+-\alpha_{A1}) + ja^2\frac{P_{B1}}{V_{B1}}\sin(\alpha_+-\alpha_{B1}) + \atop +a^2\frac{\overline{Q}_{B1}}{V_{B1}}\cos(\alpha_+-\alpha_{B1}) + ja\frac{P_{C1}}{V_{C1}}\sin(\alpha_+-\alpha_{C1}) + a\frac{\overline{Q}_{C1}}{V_{C1}}\cos(\alpha_+-\alpha_{C1}) \right| \cdot \overline{q} \right) +$$

$$+ V_+ \sqrt{\delta_u^2+\delta_A^2} \cdot \left| \sum_{x=A,B,C}\left( \frac{P_{x1}}{V_{x1}}\cos(\alpha_+-\alpha_{x1}) + j\frac{\overline{Q}_{x1}}{V_{x1}}\sin(\alpha_+-\alpha_{x1}) + j\frac{P_{x1}}{V_{x1}}\sin(\alpha_+-\alpha_{x1}) + \frac{\overline{Q}_{x1}}{V_{x1}}\cos(\alpha_+-\alpha_{x1}) \right) \right| \cdot \overline{z}$$

   où

$$a = 1\angle 120° ;$$

   j est l'unité imaginaire ;
   $\delta_U = V_-/V_+$ et $\delta_A = V_0/V_+$ sont les degrés de déséquilibre et d'asymétrie, respectivement, des tensions de phase ; et
   $\overline{p}, \overline{q}, \overline{z}$ sont les vecteurs unitaires orthogonaux définissant l'espace lui-même du vecteur de puissance de déséquilibre.

2. Procédé selon la revendication 1, **caractérisé en ce qu'**il comprend en outre une étape initiale d'acquisition de valeurs instantanées de tension ($v_A$, $v_B$, $v_C$) et d'intensité ($i_A$, $i_B$, ic) des phases (A, B, C) en un point du réseau électrique et de séparation des composants de celui-ci à la fréquence fondamentale ($v_{A1}$, $v_{B1}$, $v_{C1}$), ($i_{A1}$, $i_{B1}$, $i_{C1}$), lesdites valeurs étant utilisées à l'étape i) pour obtenir les valeurs effectives et les arguments des tensions et courants de phase à la fréquence fondamentale du réseau électrique.

3. Procédé selon l'une quelconque des revendications précédentes, **caractérisé en ce qu'**il comprend en outre une étape de calcul d'un composant ($\overline{S}_{ui}$) du vecteur de puissance de déséquilibre déterminant les effets combinés de déséquilibres de tension et de charge selon l'expression suivante :

$$\overline{S}_{ui} = V_{+} \sqrt{2 + 2\delta_u^2 + 2\delta_A^2} \cdot \left( \left| \begin{array}{l} \dfrac{P_{A1}}{V_{A1}} \cos(\alpha_{+} - \alpha_{A1}) + j\dfrac{\overline{Q}_{A1}}{V_{A1}} \sin(\alpha_{+} - \alpha_{1}) + a^2 \dfrac{P_{B1}}{V_{B1}} \cos(\alpha_{+} - \alpha_{B1}) + \\ + j a^2 \dfrac{\overline{Q}_{B1}}{V_{B1}} \sin(\alpha_{+} - \alpha_{B1}) + a\dfrac{P_{C1}}{V_{C1}} \cos(\alpha_{+} - \alpha_{C1}) + j a\dfrac{\overline{Q}_{C1}}{V_{C1}} \sin(\alpha_{+} - \alpha_{C1}) \end{array} \right| \cdot \overline{p} \right) +$$

$$+ V_{+} \sqrt{2 + 2\delta_u^2 + 2\delta_A^2} \cdot \left( \left| \begin{array}{l} j\dfrac{P_{A1}}{V_{A1}} \sin(\alpha_{+} - \alpha_{A1}) + \dfrac{\overline{Q}_{A1}}{V_{A1}} \cos(\alpha_{+} - \alpha_{A1}) + j a^2 \dfrac{P_{B1}}{V_{B1}} \sin(\alpha_{+} - \alpha_{B1}) + \\ + a^2 \dfrac{\overline{Q}_{B1}}{V_{B1}} \cos(\alpha_{+} - \alpha_{B1}) + j a\dfrac{P_{C1}}{V_{C1}} \sin(\alpha_{+} - \alpha_{C1}) + a\dfrac{\overline{Q}_{C1}}{V_{C1}} \cos(\alpha_{+} - \alpha_{C1}) \end{array} \right| \cdot \overline{q} \right)$$

4.  Procédé selon l'une quelconque des revendications précédentes, **caractérisé en ce qu'**il comprend en outre une étape de calcul d'un composant ($\overline{S}_{uv}$) du vecteur de puissance de déséquilibre déterminant l'effet exclusif de déséquilibres de tension selon l'équation suivante :

$$\overline{S}_{uv} = V_{+} \sqrt{\delta_u^2 + \delta_A^2} \cdot \left| \sum_{x=A,B,C} \left( \dfrac{P_{x1}}{V_{x1}} \cos(\alpha_{+} - \alpha_{x1}) + j\dfrac{\overline{Q}_{x1}}{V_{x1}} \sin(\alpha_{+} - \alpha_{x1}) + j\dfrac{P_{x1}}{V_{x1}} \sin(\alpha_{+} - \alpha_{x1}) + \dfrac{\overline{Q}_{x1}}{V_{x1}} \cos(\alpha_{+} - \alpha_{x1}) \right) \right| \cdot \overline{z}$$

5.  Procédé selon l'une quelconque des revendications 1 et 2, **caractérisé en ce qu'**il comprend en outre :

    - une étape de calcul d'un composant ($\overline{S}_{ui}$) du vecteur de puissance de déséquilibre déterminant les effets combinés de déséquilibres de tension et de charge selon l'expression suivante :

$$\overline{S}_{ui} = V_{+} \sqrt{2 + 2\delta_u^2 + 2\delta_A^2} \cdot \left( \left| \begin{array}{l} \dfrac{P_{A1}}{V_{A1}} \cos(\alpha_{+} - \alpha_{A1}) + j\dfrac{\overline{Q}_{A1}}{V_{A1}} \sin(\alpha_{+} - \alpha_{1}) + a^2 \dfrac{P_{B1}}{V_{B1}} \cos(\alpha_{+} - \alpha_{B1}) + \\ + j a^2 \dfrac{\overline{Q}_{B1}}{V_{B1}} \sin(\alpha_{+} - \alpha_{B1}) + a\dfrac{P_{C1}}{V_{C1}} \cos(\alpha_{+} - \alpha_{C1}) + j a\dfrac{\overline{Q}_{C1}}{V_{C1}} \sin(\alpha_{+} - \alpha_{C1}) \end{array} \right| \cdot \overline{p} \right) +$$

$$+ V_{+} \sqrt{2 + 2\delta_u^2 + 2\delta_A^2} \cdot \left( \left| \begin{array}{l} j\dfrac{P_{A1}}{V_{A1}} \sin(\alpha_{+} - \alpha_{A1}) + \dfrac{\overline{Q}_{A1}}{V_{A1}} \cos(\alpha_{+} - \alpha_{A1}) + j a^2 \dfrac{P_{B1}}{V_{B1}} \sin(\alpha_{+} - \alpha_{B1}) + \\ + a^2 \dfrac{\overline{Q}_{B1}}{V_{B1}} \cos(\alpha_{+} - \alpha_{B1}) + j a\dfrac{P_{C1}}{V_{C1}} \sin(\alpha_{+} - \alpha_{C1}) + a\dfrac{\overline{Q}_{C1}}{V_{C1}} \cos(\alpha_{+} - \alpha_{C1}) \end{array} \right| \cdot \overline{q} \right)$$

    - une étape de calcul d'un composant ($\overline{S}_{uv}$) du vecteur de puissance de déséquilibre déterminant l'effet exclusif des déséquilibres de tension selon l'équation suivante :

$$\overline{S}_{uv} = V_{+} \sqrt{\delta_u^2 + \delta_A^2} \cdot \left| \sum_{x=A,B,C} \left( \dfrac{P_{x1}}{V_{x1}} \cos(\alpha_{+} - \alpha_{x1}) + j\dfrac{\overline{Q}_{x1}}{V_{x1}} \sin(\alpha_{+} - \alpha_{x1}) + j\dfrac{P_{x1}}{V_{x1}} \sin(\alpha_{+} - \alpha_{x1}) + \dfrac{\overline{Q}_{x1}}{V_{x1}} \cos(\alpha_{+} - \alpha_{x1}) \right) \right| \cdot \overline{z}$$

6.  Procédé selon la revendication 5, **caractérisé en ce qu'**il comprend en outre une étape de présentation visuelle de la valeur calculée d'au moins un élément parmi le vecteur de puissance de déséquilibre ($\overline{S}_u$), son composant $\overline{S}_{ui}$ et son composant $\overline{S}_{uv}$.

7.  Procédé selon l'une quelconque des revendications 5 et 6, **caractérisé en ce qu'**il comprend en outre une étape d'émission d'une alarme lorsque la valeur calculée d'au moins un élément parmi le vecteur de puissance de déséquilibre ($\overline{S}_u$), son composant $\overline{S}_{ui}$ et son composant $\overline{S}_{uv}$ dépasse un seuil donné.

8.  Système de mesure de déséquilibres sur un réseau électrique, comprenant :

- un module d'analyse (14) configuré pour obtenir des valeurs effectives ($V_{A1}$, $V_{B1}$, $V_{C1}$) et des arguments ($\alpha_{A1}$, $\alpha_{B1}$, $\alpha_{C1}$) des tensions de phase à la fréquence fondamentale, ainsi que des valeurs effectives ($I_{A1}$, $I_{B1}$, $I_{C1}$) et des arguments ($\beta_{A1}$, $\beta_{B1}$, $\beta_{C1}$) des courants de phase à la fréquence fondamentale du réseau électrique ;
- un module symétrique (15) configuré pour obtenir la valeur effective ($V_+ = V_{A1+}$) et l'argument ($\alpha_+ = \alpha_{A1+}$) des tensions de séquence positives et des valeurs effectives de la tension de séquence négative ($V_- = V_{A1}$) et de la tension de séquence zéro ($V_o = V_{A1o}$);
- un module de puissance active et réactive (16) configuré pour obtenir la puissance active ($P_{A1}$, $P_{B1}$, $P_{C1}$) et la puissance réactive ($\overline{Q}_{A1}$, $\overline{Q}_{B1}$, $\overline{Q}_{C1}$) de chacune des phases à la fréquence fondamentale ;
- un module de vecteur de puissance de déséquilibre (17), configuré pour calculer la valeur du vecteur de puissance de déséquilibre ($\overline{S}_u$) selon l'équation suivante :

$$
\begin{aligned}
\overline{S}_u = {} & V_+ \sqrt{2 + 2\delta_u^2 + 2\delta_A^2} \cdot \left( \left| \begin{array}{l} \dfrac{P_{A1}}{V_{A1}}\cos(\alpha_+ - \alpha_{A1}) + j\dfrac{\overline{Q}_{A1}}{V_{A1}}\sin(\alpha_+ - \alpha_1) + a^2\dfrac{P_{B1}}{V_{B1}}\cos(\alpha_+ - \alpha_{B1}) + \\[2mm] + j\,a^2\dfrac{\overline{Q}_{B1}}{V_{B1}}\sin(\alpha_+ - \alpha_{B1}) + a\dfrac{P_{C1}}{V_{C1}}\cos(\alpha_+ - \alpha_{C1}) + j\,a\dfrac{\overline{Q}_{C1}}{V_{C1}}\sin(\alpha_+ - \alpha_{C1}) \end{array} \right| \cdot \overline{p} \right) + \\[4mm]
& + V_+ \sqrt{2 + 2\delta_u^2 + 2\delta_A^2} \cdot \left( \left| \begin{array}{l} j\dfrac{P_{A1}}{V_{A1}}\sin(\alpha_+ - \alpha_{A1}) + \dfrac{\overline{Q}_{A1}}{V_{A1}}\cos(\alpha_+ - \alpha_{A1}) + j\,a^2\dfrac{P_{B1}}{V_{B1}}\sin(\alpha_+ - \alpha_{B1}) + \\[2mm] + a^2\dfrac{\overline{Q}_{B1}}{V_{B1}}\cos(\alpha_+ - \alpha_{B1}) + j\,a\dfrac{P_{C1}}{V_{C1}}\sin(\alpha_+ - \alpha_{C1}) + a\dfrac{\overline{Q}_{C1}}{V_{C1}}\cos(\alpha_+ - \alpha_{C1}) \end{array} \right| \cdot \overline{q} \right) + \\[4mm]
& + V_+ \sqrt{\delta_u^2 + \delta_A^2} \cdot \left| \sum_{x=A,B,C} \left( \dfrac{P_{x1}}{V_{x1}}\cos(\alpha_+ - \alpha_{x1}) + j\dfrac{\overline{Q}_{x1}}{V_{x1}}\sin(\alpha_+ - \alpha_{x1}) + j\dfrac{P_{x1}}{V_{x1}}\sin(\alpha_+ - \alpha_{x1}) + \dfrac{\overline{Q}_{x1}}{V_{x1}}\cos(\alpha_+ - \alpha_{x1}) \right) \right| \cdot \overline{z}
\end{aligned}
$$

où

$$ a = 1 \angle 120° \; ; $$

j est l'unité imaginaire ;

$\delta_U = V_-/V_+$ et $\delta_A = V_0/V_+$ sont les degrés de déséquilibre et d'asymétrie, respectivement, des tensions de phase ; et

$\overline{p}, \overline{q}, \overline{z}$ sont les vecteurs unitaires orthogonaux définissant l'espace lui-même du vecteur de puissance de déséquilibre ; et

- un module d'informations configuré pour fournir des informations à propos de la valeur calculée du vecteur de puissance de déséquilibre.

9. Système selon la revendication 8, **caractérisé en ce qu'**il comprend en outre un module d'acquisition (13) configuré pour acquérir les valeurs instantanées de tension ($v_A$, vc) et d'intensité ($i_A$, $i_B$, $i_C$) des phases (A, B, C) en un point du réseau électrique et séparer les composants associés à la fréquence fondamentale ($v_{A1}$, $v_{B1}$, $v_{C1}$), ($i_{A1}$, $i_{B1}$, $i_{C1}$), lesdites valeurs étant utilisées par le module d'analyse (14) pour obtenir les valeurs effectives et les arguments des tensions et courants de phase à la fréquence fondamentale du réseau électrique.

10. Système selon l'une quelconque des revendications 8 et 9, **caractérisé en ce que** le module de vecteur de puissance de déséquilibre (17) est en outre configuré pour calculer un composant ($\overline{S}_{ui}$) du vecteur de puissance de déséquilibre déterminant les effets combinés de déséquilibres de tension et de charge selon l'expression suivante :

$$\overline{S}_{ui} = V_+ \sqrt{2 + 2\delta_u^2 + 2\delta_A^2} \cdot \left( \left| \begin{array}{l} \dfrac{P_{A1}}{V_{A1}} \cos(\alpha_+ - \alpha_{A1}) + j\dfrac{\overline{Q}_{A1}}{V_{A1}} \sin(\alpha_+ - \alpha_1) + a^2 \dfrac{P_{B1}}{V_{B1}} \cos(\alpha_+ - \alpha_{B1}) + \\ + ja^2 \dfrac{\overline{Q}_{B1}}{V_{B1}} \sin(\alpha_+ - \alpha_{B1}) + a\dfrac{P_{C1}}{V_{C1}} \cos(\alpha_+ - \alpha_{C1}) + ja\dfrac{\overline{Q}_{C1}}{V_{C1}} \sin(\alpha_+ - \alpha_{C1}) \end{array} \right| \cdot \overline{p} \right) + $$

$$+ V_+ \sqrt{2 + 2\delta_u^2 + 2\delta_A^2} \cdot \left( \left| \begin{array}{l} j\dfrac{P_{A1}}{V_{A1}} \sin(\alpha_+ - \alpha_{A1}) + \dfrac{\overline{Q}_{A1}}{V_{A1}} \cos(\alpha_+ - \alpha_{A1}) + ja^2 \dfrac{P_{B1}}{V_{B1}} \sin(\alpha_+ - \alpha_{B1}) + \\ + a^2 \dfrac{\overline{Q}_{B1}}{V_{B1}} \cos(\alpha_+ - \alpha_{B1}) + ja\dfrac{P_{C1}}{V_{C1}} \sin(\alpha_+ - \alpha_{C1}) + a\dfrac{\overline{Q}_{C1}}{V_{C1}} \cos(\alpha_+ - \alpha_{C1}) \end{array} \right| \cdot \overline{q} \right)$$

**11.** Système selon l'une quelconque des revendications 8 à 10, **caractérisé en ce que** le module de vecteur de puissance de déséquilibre (17) est en outre configuré pour calculer un composant ($\overline{S}_{uv}$) du vecteur de puissance de déséquilibre déterminant l'effet exclusif des déséquilibres de tension selon l'équation suivante :

$$\overline{S}_{uv} = V_+ \sqrt{\delta_u^2 + \delta_A^2} \cdot \left| \sum_{x=A,B,C} \left( \dfrac{P_{x1}}{V_{x1}} \cos(\alpha_+ - \alpha_{x1}) + j\dfrac{\overline{Q}_{x1}}{V_{x1}} \sin(\alpha_+ - \alpha_{x1}) + j\dfrac{P_{x1}}{V_{x1}} \sin(\alpha_+ - \alpha_{x1}) + \dfrac{\overline{Q}_{x1}}{V_{x1}} \cos(\alpha_+ - \alpha_{x1}) \right) \right| \cdot \overline{z}$$

**12.** Système selon l'une quelconque des revendications 8 et 9, **caractérisé en ce que** le module de vecteur de puissance de déséquilibre (17) est en outre configuré pour calculer :

- un composant ($\overline{S}_{ui}$) du vecteur de puissance de déséquilibre déterminant les effets combinés de déséquilibres de tension et de charge selon l'expression suivante :

$$\overline{S}_{ui} = V_+ \sqrt{2 + 2\delta_u^2 + 2\delta_A^2} \cdot \left( \left| \begin{array}{l} \dfrac{P_{A1}}{V_{A1}} \cos(\alpha_+ - \alpha_{A1}) + j\dfrac{\overline{Q}_{A1}}{V_{A1}} \sin(\alpha_+ - \alpha_1) + a^2 \dfrac{P_{B1}}{V_{B1}} \cos(\alpha_+ - \alpha_{B1}) + \\ + ja^2 \dfrac{\overline{Q}_{B1}}{V_{B1}} \sin(\alpha_+ - \alpha_{B1}) + a\dfrac{P_{C1}}{V_{C1}} \cos(\alpha_+ - \alpha_{C1}) + ja\dfrac{\overline{Q}_{C1}}{V_{C1}} \sin(\alpha_+ - \alpha_{C1}) \end{array} \right| \cdot \overline{p} \right) + $$

$$+ V_+ \sqrt{2 + 2\delta_u^2 + 2\delta_A^2} \cdot \left( \left| \begin{array}{l} j\dfrac{P_{A1}}{V_{A1}} \sin(\alpha_+ - \alpha_{A1}) + \dfrac{\overline{Q}_{A1}}{V_{A1}} \cos(\alpha_+ - \alpha_{A1}) + ja^2 \dfrac{P_{B1}}{V_{B1}} \sin(\alpha_+ - \alpha_{B1}) + \\ + a^2 \dfrac{\overline{Q}_{B1}}{V_{B1}} \cos(\alpha_+ - \alpha_{B1}) + ja\dfrac{P_{C1}}{V_{C1}} \sin(\alpha_+ - \alpha_{C1}) + a\dfrac{\overline{Q}_{C1}}{V_{C1}} \cos(\alpha_+ - \alpha_{C1}) \end{array} \right| \cdot \overline{q} \right)$$

- un composant ($\overline{S}_{uv}$) du vecteur de puissance de déséquilibre déterminant l'effet exclusif des déséquilibres de tension selon l'équation suivante :

$$\overline{S}_{uv} = V_+ \sqrt{\delta_u^2 + \delta_A^2} \cdot \left| \sum_{x=A,B,C} \left( \dfrac{P_{x1}}{V_{x1}} \cos(\alpha_+ - \alpha_{x1}) + j\dfrac{\overline{Q}_{x1}}{V_{x1}} \sin(\alpha_+ - \alpha_{x1}) + j\dfrac{P_{x1}}{V_{x1}} \sin(\alpha_+ - \alpha_{x1}) + \dfrac{\overline{Q}_{x1}}{V_{x1}} \cos(\alpha_+ - \alpha_{x1}) \right) \right| \cdot \overline{z}$$

**13.** Système selon la revendication 12, **caractérisé en ce que** le module d'informations est un module d'affichage (18) configuré pour représenter visuellement lesdites informations consistant en au moins un élément parmi la valeur calculée et la représentation graphique de ladite valeur d'au moins un élément parmi la valeur calculée du vecteur de puissance de déséquilibre, son composant $\overline{S}_{ui}$ et son composant $\overline{S}_{uv}$.

**14.** Système selon l'une quelconque des revendications 12 et 13, **caractérisé en ce que** le module d'informations est un module d'alarme configuré pour émettre une alarme lorsque la valeur calculée d'au moins un élément parmi le vecteur de puissance de déséquilibre ($\overline{S}_u$), son composant $\overline{S}_{ui}$ et son composant $\overline{S}_{uv}$ dépasse un seuil donné.

15. Système selon l'une quelconque des revendications 8 à 13, **caractérisé en ce qu'il** comprend en outre :

- des capteurs de mesure de tension et d'intensité (8) pour mesurer les valeurs instantanées de tension et d'intensité ;
- un conditionneur de signal (9) pour adapter le courant secondaire de chaque capteur de mesure (8) à la tension applicable aux entrées analogiques d'une carte d'acquisition (10) ;
- une carte d'acquisition (10) convertissant des signaux analogiques en une série d'échantillons discrets utilisés comme entrée dans le module d'acquisition (13) ;
- un système de traitement (11) connectant la carte d'acquisition (10) au module d'acquisition (13) ; et
- un dispositif d'affichage (12) connecté au module d'affichage (18) pour présenter visuellement au moins une valeur calculée par le système de mesure.

FIG. 1

FIG. 2

FIG. 3

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- ES 2316280 B1

- EP 2149795 A1

**Non-patent literature cited in the description**

- **L.S. CZARNECKI.** Power related phenomena in three-phase unbalanced systems. *IEEE Trans on Power Delivery,* July 1995, vol. 10 (3

- **A. E. EMANUEL.** The Buchholz-Goodhue Apparent Power definition: The practical approach for non-sinusoidal and unbalanced systems. *IEEE Trans on Power Delivery,* April 1998, vol. 13 (2
- *IEEE standard 1459-2010*